(19) Europäisches Patentamt
European Patent Office
Office européen des brevets

(11) EP 3 950 767 A1

(12) EUROPEAN PATENT APPLICATION
published in accordance with Art. 153(4) EPC

(43) Date of publication:
**09.02.2022 Bulletin 2022/06**

(21) Application number: **20785083.5**

(22) Date of filing: **16.03.2020**

(51) International Patent Classification (IPC):
***C08G 61/10*** (2006.01) ***C09K 11/06*** (2006.01)
***H05B 33/10*** (2006.01) ***H01L 51/50*** (2006.01)

(52) Cooperative Patent Classification (CPC):
**C08G 61/10; C09K 11/06; H01L 51/50; H05B 33/10**

(86) International application number:
**PCT/JP2020/011319**

(87) International publication number:
**WO 2020/203203 (08.10.2020 Gazette 2020/41)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **29.03.2019 JP 2019068814**

(71) Applicant: **NIPPON STEEL Chemical & Material Co., Ltd.**
**Tokyo 103-0027 (JP)**

(72) Inventors:
- **HAYASHI Kentaro**
  **Tokyo 103-0027 (JP)**
- **INOUE Munetomo**
  **Tokyo 103-0027 (JP)**

(74) Representative: **Beckmann, Claus**
**Kraus & Weisert**
**Patentanwälte PartGmbB**
**Thomas-Wimmer-Ring 15**
**80539 München (DE)**

# (54) POLYMER FOR ORGANIC ELECTROLUMINESCENT ELEMENTS AND ORGANIC ELECTROLUMINESCENT ELEMENT

(57) A polymer for organic electroluminescent devices having high luminous efficiency and applicable to a wet process is provided. This polymer for organic electroluminescent devices is characterized in that it includes a polymer of a polyphenylene main chain represented by General Formula (1) which is used in at least one layer of an organic layer in an organic electroluminescent device formed by laminating an anode, the organic layer, and a cathode on a substrate, and which has thermally activated delayed fluorescence characteristics (TADF characteristics) (where x is a phenylene group or a linked phenylene group, L is a single bond, an aromatic hydrocarbon group, or an aromatic heterocyclic group, and A is an aromatic hydrocarbon group, an aromatic heterocyclic group, or a linked aromatic group, and satisfies S1(A) - T1(A) ≤ 0.50 (eV)).

[C1]

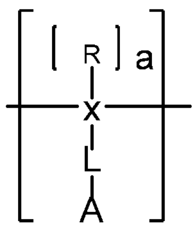

(1)

EP 3 950 767 A1

[Fig. 1]

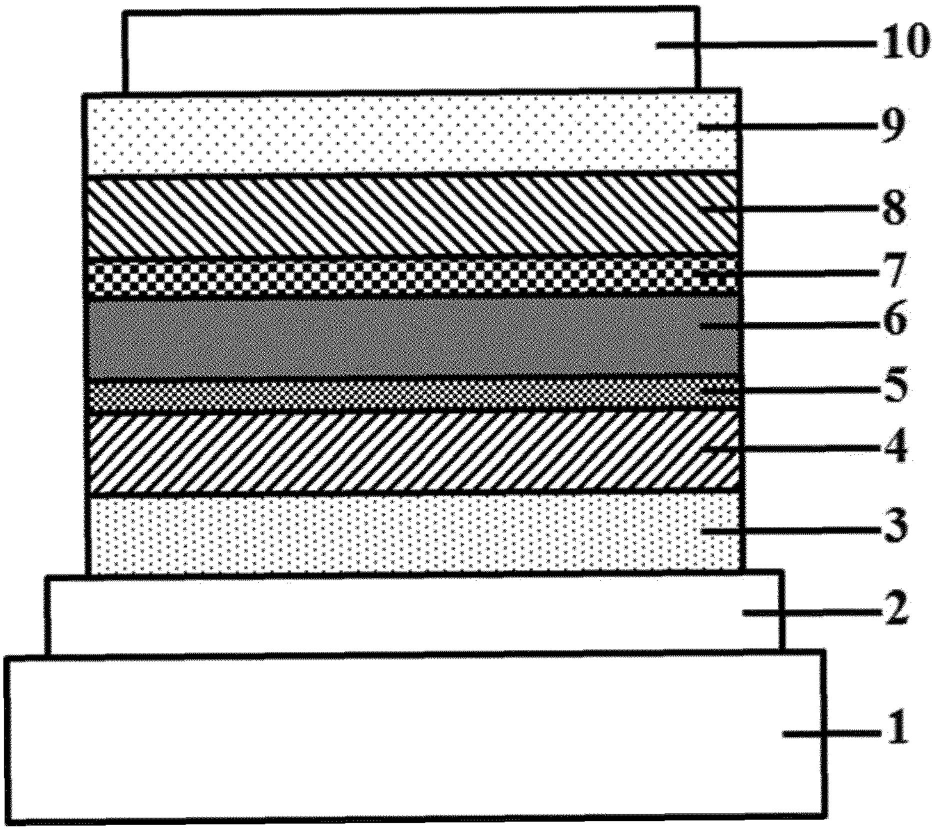

## Description

[Technical Field]

The present invention relates to a polymer for organic electroluminescent devices and an organic electroluminescent device (hereinafter referred to as an organic EL device), and more particularly relates to a material for organic EL devices in which polyphenylene having a specific fused aromatic ring structure is used.

[Background Art]

Organic EL devices have structural and design characteristics such as thin thickness, low weight, and flexibility, in addition to characteristics such as high contrast, high-speed responsiveness, and low power consumption, and practical use thereof is rapidly progressing in fields such as displays and lighting. On the other hand, there is still room for improvement in terms of brightness, efficiency, lifespan, and cost, and various studies and developments relating to materials and device structures are being performed.

In order to exhibit the characteristics of organic EL devices at a maximum level, it is required to recombine holes and electrons generated from electrodes without waste, and for this purpose, it is common to use a plurality of functional thin films in which functions of the following layers are separated: an injection layer, a transport layer, and a blocking layer for each of holes and electrons; a charge-generating layer that generates charges from other than electrodes; a light-emitting layer that efficiently converts excitons generated by recombination into light; and the like.

A process of forming a functional thin film of an organic EL device is roughly divided into a dry process represented by a vapor deposition method and a wet process represented by a spin coating method and an ink jet method. Comparing these processes, it can be said that the wet process is suitable for improving cost and productivity because the material utilization rate is high and a thin film having high flatness can be formed on a substrate having a large area.

When forming a material into a film by the wet process, there are low-molecular materials and high-molecular materials as materials, and when low-molecular materials are used, it is difficult to obtain a uniform and flat film due to segregation and phase separation associated with the crystallization of a low-molecular compound. In addition, in order to form a film by continuous lamination, it is required to cause a crosslinking reaction to proceed by heat or light after film formation for insolubilization, but when a low-molecular material is crosslinked, there is a problem that the characteristics change due to shrinkage of the material. Meanwhile, when a high-molecular material is used, crystallization of the material is inhibited, and the uniformity of a film can be increased, but it is difficult to ensure the solubility of the material, and furthermore, in a high-molecular material in which a vinyl group, an epoxy group, and the like are used, there is a problem that the characteristics easily deteriorate as compared to a low-molecular material, and further improvement is required.

As an attempt to solve the above-mentioned problems, a high-molecular material into which a carbazole structure showing a high level of characteristics as a low-molecular material is incorporated, and a light-emitting device using the same have been reported. For example, PTL 1 discloses a polymer having a carbazole structure as a main chain. Furthermore, PTL 2 and NPL 1 disclose a polymer having a carbazole structure in a side chain, but characteristics such as efficiency and durability of devices are not sufficient in both cases, and further improvement is required.

Meanwhile, in order to improve the luminous efficiency of organic EL devices, research and development of a new light-emitting method are also progressing. PTL 3 discloses an organic EL device in which the internal quantum efficiency is improved by using Triplet-Triplet Fusion (TTF), which is one of delayed fluorescence mechanisms, as compared with a fluorescence-emitting type. However, because the efficiency is low as compared to phosphorescent organic EL devices, further improvement in efficiency is required.

PTL 4 discloses an organic EL device using a thermally activated delayed fluorescence (TADF) mechanism. The TADF mechanism utilizes a phenomenon in which reverse intersystem crossing, in which excited energy moves from a triplet level to a singlet level, occurs in a material having a small energy difference between a lowest excited singlet level and a lowest excited triplet level, and it is thought that the internal quantum efficiency can be theoretically raised to 100%. Light-emitting materials using the TADF mechanism can be expected to have high luminous efficiency, but all of the compounds disclosed in the literature are low-molecular compounds, and were insufficient as materials to be applied to the wet process from the viewpoint that it is difficult to form a laminated film.

[Citation List]

[Patent Literature]

[PTL 1] WO 2013/057908 A
[PTL 2] JP 2004-18787 A
[PTL 3] WO 2010/134350 A
[PTL 4] WO 2011/070963 A

[Non Patent Literature]

[NPL 1] Appl. Phys. Lett. 59, 2760 (1991)

[Summary of Invention]

With the foregoing in view, it is an object of the present invention to provide a polymer for organic electroluminescent devices having high luminous efficiency and high durability and applicable to a wet process. It is another object of the present invention to provide an organic electroluminescent device using the above-mentioned polymer able to be used for lighting devices, image display devices, backlights for display devices, and the like.

As a result of diligent studies, the inventors of the present invention have found that a polymer, which has a polyphenylene structure in a main chain and has a structure containing a specific fused aromatic heterocycle, can be applied to a wet process when producing an organic electroluminescent device and can contribute to improvement of efficiency of light-emitting devices and improvement of productivity, and thereby have completed the present invention.

The present invention is a polymer for organic electroluminescent devices characterized in that the polymer for organic electroluminescent devices has a polyphenylene structure in a main chain, and contains a structural unit represented by General Formula (1) as a repeating unit, in which the structural units may be the same as or different from each other for each repeating unit, and a weight-average molecular weight is 500 or more and 500000 or less.

[C1]

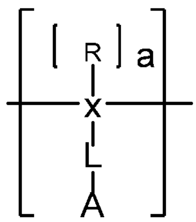

(1)

In General Formula (1), x represents a phenylene group bonded at an arbitrary position or a linked phenylene group in which 2 to 6 phenylene groups are linked at an arbitrary position.

L's each independently represent a single bond, a substituted or unsubstituted aromatic hydrocarbon group having 6 to 24 carbon atoms, or a substituted or unsubstituted aromatic heterocyclic group having 3 to 17 carbon atoms.

A's are each independently a substituted or unsubstituted aromatic hydrocarbon group having 6 to 30 carbon atoms, an aromatic heterocyclic group having 3 to 24 carbon atoms, or a linked aromatic group in which 2 to 6 of these groups are linked, and satisfy Formula (2).

$$S1(A) - T1(A) \leq 0.50 \qquad (2)$$

Substituents when L and A have a substituent are each independently a group selected from deuterium, a halogen, a cyano group, a nitro group, an alkyl group having 1 to 20 carbon atoms, an aralkyl group having 7 to 38 carbon atoms, an alkenyl group having 2 to 20 carbon atoms, an alkynyl group having 2 to 20 carbon atoms, a dialkylamino group having 2 to 40 carbon atoms, a diarylamino group having 12 to 44 carbon atoms, a diaralkylamino group having 14 to 76 carbon atoms, an acyl group having 2 to 20 carbon atoms, an acyloxy group having 2 to 20 carbon atoms, an alkoxy group having 1 to 20 carbon atoms, an alkoxycarbonyl group having 2 to 20 carbon atoms, an alkoxycarbonyloxy group having 2 to 20 carbon atoms, and an alkylsulfonyl group having 1 to 20 carbon atoms.

R's each independently represent deuterium, a halogen, a cyano group, a nitro group, an alkyl group having 1 to 20 carbon atoms, an aralkyl group having 7 to 38 carbon atoms, an alkenyl group having 2 to 20 carbon atoms, an alkynyl group having 2 to 20 carbon atoms, a dialkylamino group having 2 to 40 carbon atoms, a diarylamino group having 12 to 44 carbon atoms, a diaralkylamino group having 14 to 76 carbon atoms, an acyl group having 2 to 20 carbon

atoms, an acyloxy group having 2 to 20 carbon atoms, an alkoxy group having 1 to 20 carbon atoms, an alkoxycarbonyl group having 2 to 20 carbon atoms, an alkoxycarbonyloxy group having 2 to 20 carbon atoms, an alkylsulfonyl group having 1 to 20 carbon atoms, an aromatic hydrocarbon group having 6 to 18 carbon atoms, an aromatic heterocyclic group having 3 to 18 carbon atoms, or a linked aromatic group in which a plurality of these aromatic rings are linked. When these groups have a hydrogen atom, the hydrogen atom may be substituted with deuterium or a halogen.

a's each independently indicate an integer of 0 to 3.

In Formula (2),

S1(A): lowest excited singlet energy (eV) of partial structure A
T1(A): lowest excited triplet energy (eV) of partial structure A

Here, the partial structure A represents A-L-Ph in which x to which a substituent A-L- is bonded is substituted with a phenyl group (Ph).

The polymer for organic electroluminescent devices may contain a structural unit represented by General Formula (3) .

[C2]

$$-[-(Y)_n- \quad -(Z)_m-]_b- \qquad (3)$$

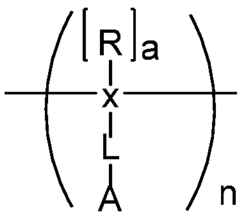

(3n)

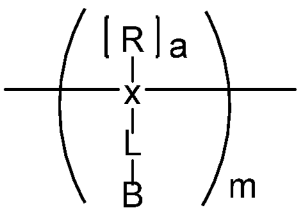

(3m)

Here, Y is a structural unit represented by Formula (3n), Z is a structural unit represented by Formula (3m), and these may be the same as or different from each other for each repeating unit.

n and m represent a molar ratio abundance, which is in a range of $0.01 \leq n \leq 1$ and $0 \leq m < 0.99$, and b represents an average number of repeating units and indicates a number of 2 to 1000.

x, A, L, R, and a are synonymous with those in General Formula (1).

B's each independently indicate a hydrogen atom, a substituted or unsubstituted aromatic hydrocarbon group having 6 to 24 carbon atoms, a substituted or unsubstituted aromatic heterocyclic group having 3 to 18 carbon atoms, or a linked aromatic group in which a plurality of these aromatic rings are linked, and satisfy Formula (4).

$$S1(B) - T1(B) > 0.50 \text{ (eV)} \qquad (4)$$

In Formula (4),

S1(B): lowest excited singlet energy (eV) of partial structure B
T1(B): lowest excited triplet energy (eV) of partial structure B

Here, the partial structure B represents B-L-Ph.

The above-mentioned polymer for organic electroluminescent devices may show thermally activated delayed fluorescence characteristics.

In General Formula (1) or (3), A may be a group generated from a structure represented by any of Formulas (5) to (9).

[C3]

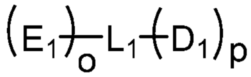

(5)

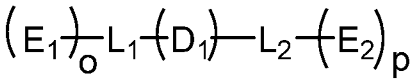

(6)

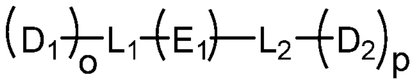

(7)

In Formulas (5), (6), and (7),
$E_1$ and $E_2$ each independently represent a structure or a substituent having electron-withdrawing properties, and $D_1$ and $D_2$ each independently represent a structure or a substituent showing electron-donating properties.

$L_1$ and $L_2$ each independently represent a single bond, a substituted or unsubstituted aromatic hydrocarbon group having 6 to 24 carbon atoms, a substituted or unsubstituted aromatic heterocyclic group having 3 to 17 carbon atoms, or a linked aromatic group in which these aromatic rings are linked.

o and p each independently represent the number of substitutions and indicate an integer of 1 to 3.

[C4]

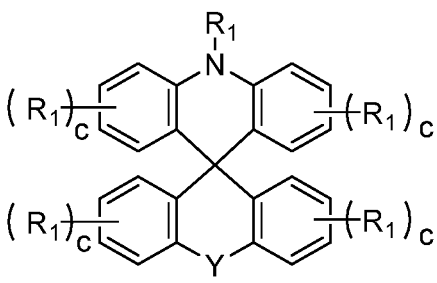

(8)

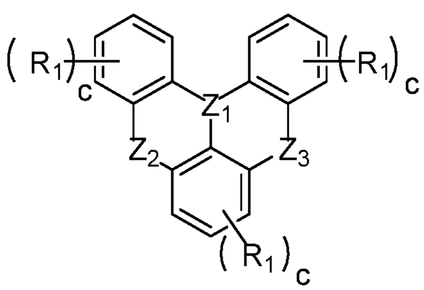

(9)

In Formulas (8) and (9),
Y's each independently represent any of a single bond, S, $SO_2$, O, N-$R_1$, or C=O.

$Z_1$'s each independently represent any of B, P=O, or P=S, and $Z_2$ and $Z_3$ each independently represent any of S, O, N-$R_1$, or C=O.

$R_1$'s each independently represent deuterium, a halogen, a cyano group, a nitro group, an alkyl group having

1 to 20 carbon atoms, an aralkyl group having 7 to 38 carbon atoms, an alkenyl group having 2 to 20 carbon atoms, an alkynyl group having 2 to 20 carbon atoms, a dialkylamino group having 2 to 40 carbon atoms, a diarylamino group having 12 to 44 carbon atoms, a diaralkylamino group having 14 to 76 carbon atoms, an acyl group having 2 to 20 carbon atoms, an acyloxy group having 2 to 20 carbon atoms, an alkoxy group having 1 to 20 carbon atoms, an alkoxycarbonyl group having 2 to 20 carbon atoms, an alkoxycarbonyloxy group having 2 to 20 carbon atoms, an alkylsulfonyl group having 1 to 20 carbon atoms, an aromatic hydrocarbon group having 6 to 18 carbon atoms, an aromatic heterocyclic group having 3 to 18 carbon atoms, or a linked aromatic group in which a plurality of these aromatic rings are linked. When these groups have a hydrogen atom, the hydrogen atom may be substituted with deuterium or a halogen.

c's each independently indicate an integer of 0 to 4, and when c is 2 or more, $R_1$'s may be bonded to each other to form a ring.

It is desirable that the polymer for organic electroluminescent devices represented by General Formula (3) satisfy Formula (10).

$$S1(P3) - T1(P3) \leq 0.50\ (eV) \qquad (10)$$

Here,

S1(P3): excited singlet energy (eV) of the polymer when b = 3
T1(P3): excited triplet energy (eV) of the polymer when b = 3.

It is desirable that the polyphenylene structure of the main chain of the above-mentioned polymer for organic electroluminescent devices be linked at a meta position or an ortho position. Furthermore, it is desirable that the solubility in toluene at 40°C be 0.1 wt% or more.

In an aspect in which the above-mentioned polymer for organic electroluminescent devices is solvent-insoluble, the polymer for organic electroluminescent devices, which is solvent-insoluble and has a reactive group at an end or a side chain of a polyphenylene structure, may be crosslinked and insolubilized by heat or energy rays.

Furthermore, the present invention is a composition for organic electroluminescent devices characterized in that the composition for organic electroluminescent devices is formed by dissolving or dispersing, in a solvent, the above-mentioned polymer for organic electroluminescent devices alone or by mixing the polymer with another material.

Furthermore, the present invention is a method for manufacturing an organic electroluminescent device characterized in that the method includes applying the above-mentioned composition for organic electroluminescent devices to form a film to obtain an organic layer.

Furthermore, the present invention is an organic electroluminescent device characterized in that the organic electroluminescent device includes an organic layer containing the above-mentioned polymer for organic electroluminescent devices.

Since the polymer for organic electroluminescent devices of the present invention has high structural stability derived from a polyphenylene chain that is a main chain, and has, in a side chain, a structural unit in which an energy difference between S1 and T1 is small, the polymer for organic electroluminescent devices is a material for organic electroluminescent devices showing high luminous efficiency due to exhibition of TADF properties, and an organic electroluminescent device in which an organic thin film formed from this material is used shows high luminous efficiency and high driving stability.

Furthermore, as a method for forming a film of the polymer for organic electroluminescent devices of the present invention, by dissolving or dispersing, in the same solvent, the polymer for organic electroluminescent devices alone or by mixing with another material to use in formation of a film as a composition for organic electroluminescent devices, it is possible to adjust charge transportability in an organic layer and a carrier balance between holes and electrons to realize an organic EL device having higher performance.

[Brief Description of Drawings]

[Fig. 1] Fig. 1 is a schematic cross-sectional view showing an example of an organic EL device.
[Fig. 2] Fig. 2 is an emission spectrum of a polymer for organic electroluminescent devices.

[Description of Embodiments]

A polymer for organic electroluminescent devices of the present invention has a polyphenylene structure in a

main chain, and contains a structural unit represented by General Formula (1) as a repeating unit. These structural units may be the same as or different from each other for each repeating unit.

In General Formula (1), x represents a phenylene group bonded at an arbitrary position or a linked phenylene group in which 2 to 6 phenylene groups are linked at an arbitrary position. It is preferably a phenylene group or a linked phenylene group in which 2 to 4 phenylene groups are linked, and more preferably a phenylene group, a biphenylene group, or a terphenylene group.

Here, the above-mentioned phenylene group and linked phenylene group can have a substituent. Furthermore, phenylene in the linked phenylene group can be linked at an ortho position, a meta position, or a para position, and is preferably linked at an ortho position or a meta position.

A is a substituted or unsubstituted aromatic hydrocarbon group having 6 to 30 carbon atoms, or an aromatic heterocyclic group having 3 to 24 carbon atoms, or a linked aromatic group in which 2 to 6 of these are linked.

A is preferably a fused heterocyclic group or a linked aromatic group containing a fused heterocyclic group. Preferred examples of the fused heterocyclic group include a carbazolyl group and an indolocarbazolyl group.

The partial structure A indicates A-L-Ph in which x to which A-L- is bonded is substituted with a phenyl group (Ph), and this partial structure A satisfies Formula (2).

S1(A) - T1(A) = ΔE (A), ΔE (A) is 0.50 eV or less, preferably 0.40 eV or less, and more preferably 0.30 eV.

Here, S1(A) and T1(A) are a lowest excited singlet energy S1 and a lowest excited triplet energy unit T1 indicated by the partial structure A, and the unit is eV.

The polymer for organic electroluminescent devices of the present invention preferably shows thermally activated delayed fluorescence (TADF) characteristics, and this is exhibited by occurrence of reverse intersystem crossing in which excited energy moves from T1 to S1. Because the reverse intersystem crossing is more likely to occur when S1 and T1 are closer to each other, a difference between S1 and T1 (S1 - T1) is preferably small.

The lowest excited singlet energy (S1) and the lowest excited triplet energy (T1) can be determined by known general experiments or calculated using a quantum mechanical calculation program.

When it is determined experimentally, it can be calculated by photoluminescence (PL) characteristics of a solution or a thin film, for example. For example, as a calculation method in a thin film, fluorescent emission and phosphorescent emission can be obtained by evaluating, at a temperature of 5 K, the emission spectrum from a thin film when being irradiated with light of 337 nm with an N2 laser after forming the dispersion of a compound in a diluted state into the thin film. From these fluorescent emission wavelength and phosphorescent emission wavelength, S1 and T1 of each compound can be obtained.

Furthermore, when the calculation is performed using a quantum mechanical calculation program, it can be performed using the quantum chemical calculation program Gaussian 16 produced by Gaussian, Inc. in the United States, for example. In the calculation, using density-functional theory (DFT), calculated values of S1 and T1 can be obtained by timedependent density-functional theory (TD-DFT) regarding a structure optimized by using B3LYP as the functional and 6-31G* as the basis function.

L is a single bond or a divalent group. The divalent group is a substituted or unsubstituted aromatic hydrocarbon group having 6 to 24 carbon atoms, a substituted or unsubstituted aromatic heterocyclic group having 3 to 17 carbon atoms, or a linked aromatic group in which a plurality of these aromatic rings are linked. It is preferably a single bond, a substituted or unsubstituted aromatic hydrocarbon group having 6 to 18 carbon atoms, a substituted or unsubstituted aromatic heterocyclic group having 3 to 15 carbon atoms, or a linked aromatic group in which 2 to 6 of these aromatic rings are linked. It is more preferably a single bond, a substituted or unsubstituted aromatic hydrocarbon group having 6 to 12 carbon atoms, a substituted or unsubstituted aromatic heterocyclic group having 3 to 12 carbon atoms, or a linked aromatic group in which 2 to 4 of these aromatic rings are linked.

In the present specification, a linked aromatic group is a group in which aromatic rings of a substituted or unsubstituted aromatic hydrocarbon group and a substituted or unsubstituted aromatic heterocyclic group are linked by direct bonds, and aromatic rings to be linked may be the same as or different from each other, and furthermore, when three or more aromatic rings are linked, they may be linearly linked or branched, and a bond (hand) may come out from an aromatic ring at the end or may come out from an aromatic ring at the middle. It may have a substituent. The number of carbon atoms of the linked aromatic group is the total number of carbon atoms that can be possessed by a substituted or unsubstituted aromatic hydrocarbon group and a substituted or unsubstituted aromatic heterocyclic group which constitute the linked aromatic group.

Linking of aromatic rings (Ar) specifically refers to one having the following structure.

Ar1-Ar2-Ar3-Ar4 (i)

Ar5-Ar6(Ar7)-Ar8 (ii)

Here, Ar1 to Ar8 are aromatic hydrocarbon groups or aromatic heterocyclic groups (aromatic rings), and each

of the aromatic rings is bonded by a direct bond. Ar1 to Ar8 are each independently different and may be any of an aromatic hydrocarbon group or an aromatic heterocyclic group. In addition, each may be linear as in Formula (i) or may be branched as in Formula (ii). In Formula (1), a position at which L is bonded to x and A may be Ar1 or Ar4 at the end, or Ar3 or Ar6 at the middle.

Specific examples of a case in which L is an unsubstituted aromatic hydrocarbon group, aromatic heterocyclic group, or a linked aromatic group include groups formed by removing hydrogen from an aromatic compound such as benzene, pentalene, indene, naphthalene, azulene, heptalene, octalene, indacene, acenaphthylene, phenalene, phenanthrene, anthracene, trindene, fluoranthene, acephenanthrylene, aceanthrylene, triphenylene, pyrene, chrysene, tetraphene, tetracene, pleiadene, picene, perylene, pentaphene, pentacene, tetraphenylene, cholanthrylene, helicene, hexaphene, rubicene, coronene, trinaphthylene, heptaphene, pyranthrene, furan, benzofuran, isobenzofuran, xanthene, oxatrene, perixanthenoxanthene, thiophene, thioxanthene, thianthrene, phenoxathiin, thionaphthene, isothianaphthene, thiophthene, thiophanthrene, pyrrole, pyrazole, tellurazole, selenazole, thiazole, isothiazole, oxazole, furazan, pyridine, pyrazine, pyrimidine, pyridazine, triazine, indolizine, indole, indoloindole, isoindole, indazole, purine, quinolizine, isoquinoline, imidazole, naphthyridine, phthalazine, quinazoline, benzodiazepine, quinoxaline, cinnoline, quinoline, pteridine, phenanthridine, acridine, perimidine, phenanthroline, phenazine, carboline, phenotellurazine, phenoselenazine, phenothiazine, phenoxazine, anthyridine, benzothiazole, benzimidazole, benzoxazole, benzoisoxazole, and benzisothiazole, or an aromatic compound in which a plurality of these are linked. Preferred examples include groups formed by removing hydrogen from a compound benzene, naphthalene, anthracene, triphenylene, pyrene, pyridine, pyrazine, pyrimidine, pyridazine, triazine, indole, indoloindole, quinoline, isoquinoline, quinoxaline, quinazoline, naphthyridine, or a compound in which 2 to 6 of these are linked.

The above-mentioned aromatic hydrocarbon group, aromatic heterocyclic group, or linked aromatic group can have a substituent, and preferred examples of this substituent include deuterium, a halogen, a cyano group, a nitro group, an alkyl group having 1 to 20 carbon atoms, an aralkyl group having 7 to 38 carbon atoms, an alkenyl group having 2 to 20 carbon atoms, an alkynyl group having 2 to 20 carbon atoms, a dialkylamino group having 2 to 40 carbon atoms, a diarylamino group having 12 to 44 carbon atoms, a diaralkylamino group having 14 to 76 carbon atoms, an acyl group having 2 to 20 carbon atoms, an acyloxy group having 2 to 20 carbon atoms, an alkoxy group having 1 to 20 carbon atoms, an alkoxycarbonyl group having 2 to 20 carbon atoms, an alkoxycarbonyloxy group having 2 to 20 carbon atoms, an alkylsulfonyl group having 1 to 20 carbon atoms, an aromatic hydrocarbon group having 6 to 24 carbon atoms, and an aromatic heterocyclic group having 3 to 17 carbon atoms.

In the present specification, regarding the number of carbon atoms when the range of the number of carbon atoms is defined for a substituted or unsubstituted aromatic hydrocarbon group, a substituted or unsubstituted aromatic heterocyclic group, and the like, substituents are excluded from calculation of the number of carbon atoms. However, it is preferable that carbon atoms including substituents be included in the above-mentioned range of the number of carbon atoms.

R’s each independently represent deuterium, a halogen, a cyano group, a nitro group, an alkyl group having 1 to 20 carbon atoms, an aralkyl group having 7 to 38 carbon atoms, an alkenyl group having 2 to 20 carbon atoms, an alkynyl group having 2 to 20 carbon atoms, a dialkylamino group having 2 to 40 carbon atoms, a diarylamino group having 12 to 44 carbon atoms, a diaralkylamino group having 14 to 76 carbon atoms, an acyl group having 2 to 20 carbon atoms, an acyloxy group having 2 to 20 carbon atoms, an alkoxy group having 1 to 20 carbon atoms, an alkoxycarbonyl group having 2 to 20 carbon atoms, an alkoxycarbonyloxy group having 2 to 20 carbon atoms, an alkylsulfonyl group having 1 to 20 carbon atoms, an aromatic hydrocarbon group having 6 to 18 carbon atoms, an aromatic heterocyclic group having 3 to 18 carbon atoms, or a linked aromatic group in which a plurality of these aromatic rings are linked. When these groups have a hydrogen atom, the hydrogen atom may be substituted with deuterium or a halogen. A preferable structure of R is an aromatic hydrocarbon group having 6 to 18 carbon atoms, an aromatic heterocyclic group having 3 to 18 carbon atoms, or a linked aromatic group in which a plurality of these aromatic rings are linked, and a more preferable structure is an aromatic hydrocarbon group having 6 to 12 carbon atoms or an aromatic heterocyclic group having 3 to 12 carbon atoms.

Specific examples of R include, but are not limited to, methyl, ethyl, propyl, butyl, pentyl, hexyl, heptyl, octyl, nonyl, decyl, and the like as an alkyl group; benzyl, pyridylmethyl, phenylethyl, naphthomethyl, naphthoethyl, and the like as an aralkyl group; vinyl, propenyl, butenyl, styryl, and the like as an alkenyl group; ethynyl, propynyl, butynyl, and the like as an alkynyl group; dimethylamino, methylethylamino, diethylamino, dipropylamino, and the like as a dialkylamino group; diphenylamino, naphthylphenylamino, dinaphthylamino, dianthranylamino, diphenanthrenylamino, and the like as a diarylamino group; dibenzylamino, benzylpyridylmethylamino, diphenylethylamino, and the like as a diaralkylamino group; an acetyl group, a propanoyl group, a benzoyl group, an acryloyl group, a methacryloyl group, and the like as an acyl group; an acetoxy group, a propanoyloxy group, a benzoyloxy group, an acryloyloxy group, a methacryloyloxy group, and the like as an acyloxy group; a methoxy group, an ethoxy group, a propoxy group, a phenoxy group, a naphthoxy group, and the like as an alkoxy group; a methoxycarbonyl group, an ethoxycarbonyl group, a propoxycarbonyl group, a phenoxycarbonyl group, a naphthoxycarbonyl group, and the like as an alkoxycarbonyl group; a methoxycarbonyloxy group, an ethoxycarbonyloxy group, a propoxycarbonyloxy group, a phenoxycarbonyloxy group, a naphthoxycarbonyloxy group, and the like as an alkoxycarbonyloxy group; a mesyl group, an ethylsulfonyl group, a propylsulfonyl group, and the like as an alkylsulfonyl group; and the same as those described for L as an aromatic hydrocarbon group, an aromatic heterocyclic group, and a linked aromatic group, except that the valences are different.

a represents the number of substitutions and indicates an integer of 0 to 3.

It is desirable that the polymer for organic electroluminescent devices of the present invention contain a structural unit represented by General Formula (3).

In General Formula (3), Y is a structural unit represented by Formula (3n), Z is a structural unit represented by Formula (3n), and these may be the same as or different from each other for each repeating unit. n and m represent a molar ratio abundance, which is in a range of $0.01 \leq n \leq 1$ and $0 \leq m < 0.99$, and b represents an average number of repeating units and indicates a number of 2 to 1000.

x, A, L, R, and a are synonymous with those in General Formula (1).

B's each independently indicate a hydrogen atom, a substituted or unsubstituted aromatic hydrocarbon group having 6 to 24 carbon atoms, a substituted or unsubstituted aromatic heterocyclic group having 3 to 18 carbon atoms, or a linked aromatic group in which a plurality of these aromatic rings are linked, and S1 and T1 of a partial structure B satisfy Formula (4).

$$S1(B) - T1(B) > 0.50 \text{ eV} \qquad (4)$$

That is, S1(B) - T1(B) = ΔE (B), ΔE (B) exceeds 0.50 eV. Here,

S1(B): lowest excited singlet energy (eV) of partial structure B
T1(B): lowest excited triplet energy (eV) of partial structure B

The partial structure B represents B-L-Ph.

In the polymer for organic electroluminescent devices of the present invention, the luminous efficiency and wavelength can be controlled by appropriately selecting the structures of the partial structures A and B.

When expecting light emission derived from the partial structure A, it is preferable that Formulas (10) and (11) be satisfied.

$$S1(B) - S1(A) \geq 0.10 \text{ eV} \qquad (10)$$

$$T1(B) - T1(A) \geq 0.10 \text{ eV} \qquad (11)$$

In this case, molar ratio abundances n and m are preferably in the range of $0.03 \leq n \leq 1$ and $0 \leq m \leq 0.97$, and more preferably in the range of $0.05 \leq n \leq 1$ and $0 \leq m \leq 0.95$.

Meanwhile, light emission derived from the partial structure B can be expected when selecting a structure satisfying Formulas (12) and (13) for the partial structure B.

$$S1(A) - S1(B) \geq 0.10 \text{ eV} \qquad (12)$$

$$T1(A) - T1(B) \geq 0.10 \text{ eV} \qquad (13)$$

In this case, molar ratio abundances n and m are preferably in the range of $0.10 \leq n \leq 0.99$ and $0.01 \leq m \leq 0.90$, and more preferably in the range of $0.20 \leq n \leq 0.99$ and $0.01 \leq m \leq 0.80$.

Examples of a case in which the structural unit of Formula (3n) and the structural unit of Formula (3m) are different for each repeating unit in the polymer represented by General Formula (1) or General Formula (3) include a polymer represented by Formula (10).

[C5]

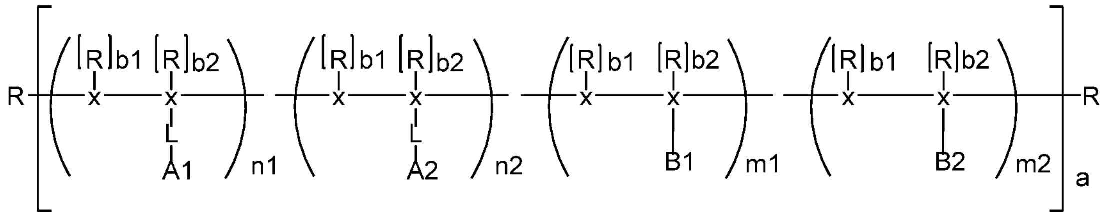

(10)

The polymer represented by Formula (10) is an example in which the structural unit of Formula (3n) has structural units of A1 and A2 in molar ratio abundances of n1 and n2, respectively, and the structural unit of Formula (3m) has structural units of B1 and B2 in molar ratio abundances of m1 and m2, respectively.

Here, the sum of the molar ratio abundances n1 and n2 matches n in General Formula (3), and the sum of the molar ratio abundances m1 and m2 matches m.

In Formula (10), an example in which the structural units of Formula (3n) and Formula (3m) consist of two kinds of different structural unit is shown, but the structural units of Formula (3n) and Formula (3m) may each independently be a repetition of three or more different kinds of structural units.

It is essential that the polymer for organic electroluminescent devices of the present invention contain a repeating structural unit represented by General Formula (1), but is preferably a polyphenylene main chain.

As same as the above-mentioned group L, a group linking each repeating structural unit can be a single bond, a substituted or unsubstituted aromatic hydrocarbon group, a substituted or unsubstituted aromatic heterocyclic group, or a linked aromatic group in which these aromatic rings are linked, but is preferably a single bond or a phenylene group.

The polymer for organic electroluminescent devices of the present invention may contain a unit other than the structural unit represented by General Formula (1), but it is desirable that the polymer contain the structural unit represented by General Formula (1) in an amount of 1 mol% or more, preferably in an amount of 5 mol% or more.

The weight-average molecular weight of the polymer for organic electroluminescent devices of the present invention is 500 or more and 500000 or less, but is preferably 800 or more and 400000 or less and is more preferably 1000 or more and 300000 or less from the viewpoint of balance of solubility, film forming properties by application, durability against heat, charge, and excitons, and the like. The number average molecular weight (Mn) is preferably 500 or more and 50000 or less and is more preferably 1000 or more and 30000 or less, and the ratio (Mw/Mn) is preferably 1.00 to 5.00 and is more preferably 1.50 to 4.00.

In the soluble polymer for organic electroluminescent devices of the present invention, it is possible to impart a reactive group, which reacts in response to an external stimulus such as heat or light, to the end or side chain of the polyphenylene structure that is the main chain represented by General Formula (1), or a group constituting R, L, or A bonded to the main chain. The polymer to which a reactive substituent is imparted can be insolubilized by treatment such as heating or exposure after forming a film by application (where the solubility in toluene at 40°C is less than 0.5 wt%), and continuous formation of a laminated film by application becomes possible.

The reactive substituent is not limited as long as it is a substituent having reactivity such as allowing polymerization, fusion, crosslinking, and coupling by an external stimulus such as heat or light, and specific examples thereof include a hydroxyl group, a carbonyl group, a carboxyl group, an amino group, an azide group, a hydrazide group, a thiol group, a disulfide group, an acid anhydride, an oxazoline group, a vinyl group, an acrylic group, a methacryl group, a haloacetyl group, an oxirane ring, an oxetane ring, a cycloalkane group such as cyclopropane and cyclobutane, a benzocyclobutene group, and the like. When the reaction occurs with two or more of these reactive substituents involved, two or more reactive substituents are imparted.

The soluble polymer for organic electroluminescent devices of the present invention may be solvent-soluble or insoluble. When it is soluble, film formation by an application method becomes easy. When it is insoluble, a film formation by application becomes possible by dispersing in a solvent. It is advantageous to obtain a cured type polymer for organic electroluminescent devices by using the soluble polymer for organic electroluminescent devices and crosslinking and curing it after application. In addition, both soluble and cured type polymers have characteristics as the polymer for organic electroluminescent devices.

In the case of the soluble polymer, the solubility in toluene at 40°C is preferably 0.1 wt% or more.

In General Formula (1) or (3) representing the polymer for organic electroluminescent devices of the present invention, a group generated from the structure represented by any of Formulas (5) to (9) is a preferable form of A. A is a monovalent group in which one hydrogen atom at an arbitrary position is removed from the structures of Formulas (5)

to (9).

In Formulas (5), (6), and (7),

$E_1$ and $E_2$ each independently represent a structure or a substituent having electron-withdrawing properties, and $D_1$ and $D_2$ each independently represent a structure or a substituent showing electron-donating properties.

$L_1$ and $L_2$ each independently represent a single bond, a substituted or unsubstituted aromatic hydrocarbon group having 6 to 24 carbon atoms, a substituted or unsubstituted aromatic heterocyclic group having 3 to 17 carbon atoms, or a linked aromatic group in which these aromatic rings are linked.

o and p each independently represent the number of substitutions and indicate an integer of 1 to 3.

In Formulas (8) and (9),

Y's each independently represent any of a single bond, S, $SO_2$, O, N-$R_1$, or C=O.

$Z_1$'s each independently represent any of B, P=O, or P=S, and $Z_2$ and $Z_3$ each independently represent any of S, O, N-$R_1$, or C=O.

$R_1$'s each independently represent deuterium, a halogen, a cyano group, a nitro group, an alkyl group having 1 to 20 carbon atoms, an aralkyl group having 7 to 38 carbon atoms, an alkenyl group having 2 to 20 carbon atoms, an alkynyl group having 2 to 20 carbon atoms, a dialkylamino group having 2 to 40 carbon atoms, a diarylamino group having 12 to 44 carbon atoms, a diaralkylamino group having 14 to 76 carbon atoms, an acyl group having 2 to 20 carbon atoms, an acyloxy group having 2 to 20 carbon atoms, an alkoxy group having 1 to 20 carbon atoms, an alkoxycarbonyl group having 2 to 20 carbon atoms, an alkoxycarbonyloxy group having 2 to 20 carbon atoms, an alkylsulfonyl group having 1 to 20 carbon atoms, an aromatic hydrocarbon group having 6 to 18 carbon atoms, an aromatic heterocyclic group having 3 to 18 carbon atoms, or a linked aromatic group in which a plurality of these aromatic rings are linked. When these groups have a hydrogen atom, the hydrogen atom may be substituted with deuterium or a halogen.

c represents the number of substitutions, and c's each independently indicate an integer of 0 to 4, and when c is 2 or more, $R_1$'s may be bonded to each other to form a ring.

In Formulas (5), (6), and (7), specific examples of the structure or substituent having electron-withdrawing properties include groups generated by removing hydrogen from an aromatic compound such as peri-xanthenoxanthene, thioxanthene, thianthrene, phenoxathiin, thionaphthene, isothianaphthene, thiophthene, thiophanthrene, pyrazole, tellurazole, selenazole, thiazole, isothiazole, oxazole, oxadiazole, oxatriazole, pyridine, pyrazine, pyrimidine, pyridazine, triazine, indolizine, isoindole, purine, quinolizine, isoquinoline, imidazole, naphthyridine, phthalazine, quinazoline, benzodiazepine, quinoxaline, cinnoline, quinoline, pteridine, phenanthridine, acridine, perimidine, phenanthroline, phenazine, phenotellurazine, phenoselenazine, anthyridine, benzothiazole, benzimidazole, benzoxazole, benzoisoxazole, benzisothiazole, fluorenone, anthraquinone, phthalimide, benzofuropyrimidine, pyridine, pyrrolidine, indolizine, benzoquinoline, a trifluoromethyl group, acridan, aromatic hydrocarbon substituted with a halogen, or aromatic hydrocarbon substituted with a cyano group. Preferred examples include groups generated by removing hydrogen from a pyridine, pyrazine, pyrimidine, pyridazine, triazine, quinoline, isoquinoline, quinoxaline, quinazoline, naphthyridine, or an aromatic hydrocarbon compound substituted with cyano group. In the case of an unsubstituted linked aromatic group, examples include, but are not limited to, a group in which a plurality of these groups are bonded by direct bonds.

Furthermore, examples of the structure or substituent having electron-donating properties include groups generated by removing hydrogen from an aromatic compound such as benzofuran, isobenzofuran, xanthene, oxathrene, dibenzofuran, thioxanthene, thianthrene, phenoxathiin, thionaphthene, isothianaphthene, thiophthene, thiophanthrene, dibenzothiophene, indoloindole, indolocarbazole, carbazole, oxathiazole, phenanthroline, phenazine, carboline, phenotellurazine, phenoselenazine, phenothiazine, phenoxazine, anthyridine, benzothiazole, acridine, acridan, benzothieno carbazole, benzofuranyl carbazole, benzimidazole, benzoxazole, benzoisoxazole, or benzisothiazole. Preferred examples include groups formed by removing hydrogen from carbazole, indolocarbazole, dibenzofuran, dibenzothiophene, carboline, phenoxazine, or phenothiazine. In the case of an unsubstituted linked aromatic group, examples include, but are not limited to, a group in which a plurality of these groups are bonded by direct bonds.

Preferred examples of the group generated from the structures represented by Formulas (5), (6), and (7) are shown below.

[C6]

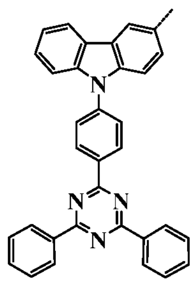 5-1 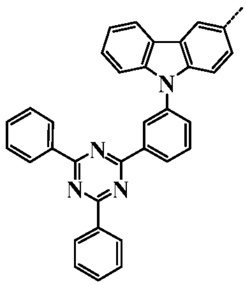 5-2 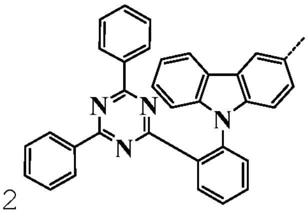 5-3

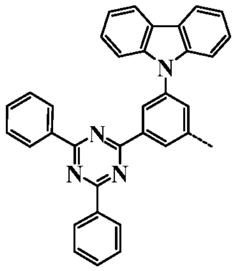 5-4 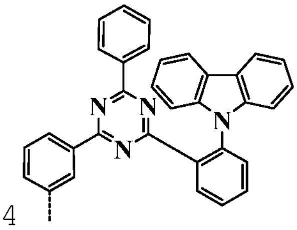 5-5 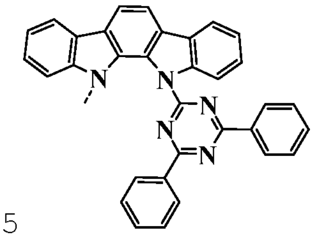 5-6

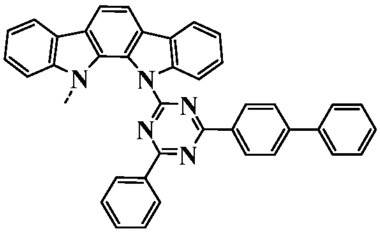 5-7 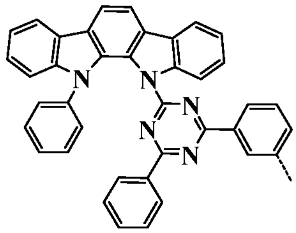 5-8 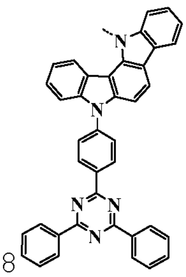 5-9

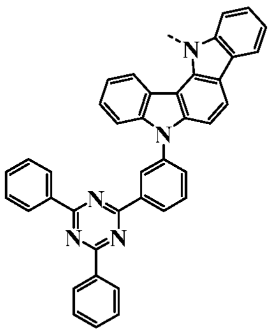 5-10 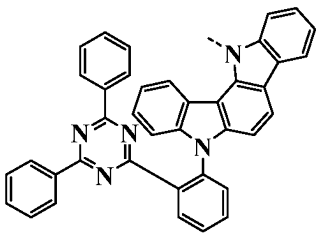 5-11

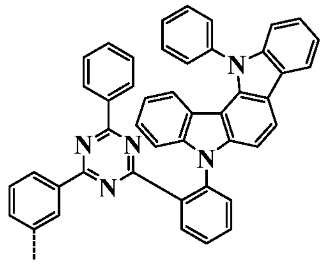 5-12 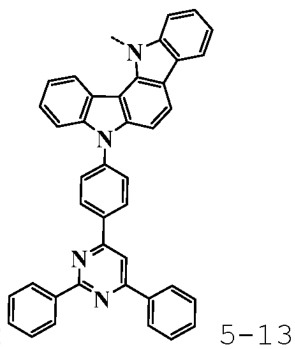 5-13 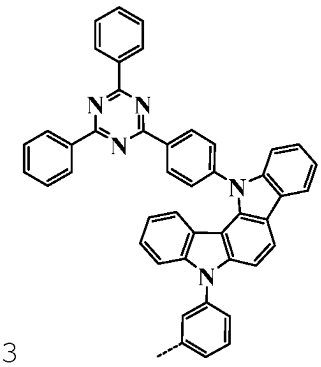 5-14

[C7]

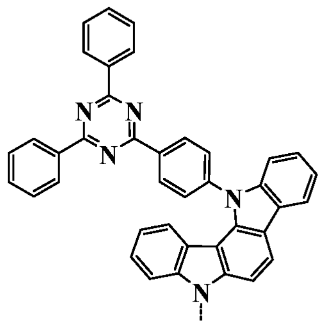
5-15
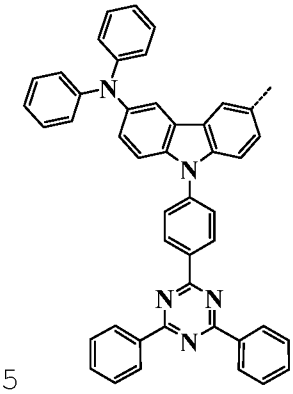
5-16

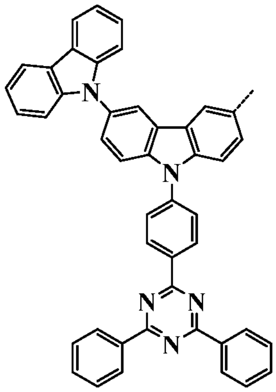
5-17
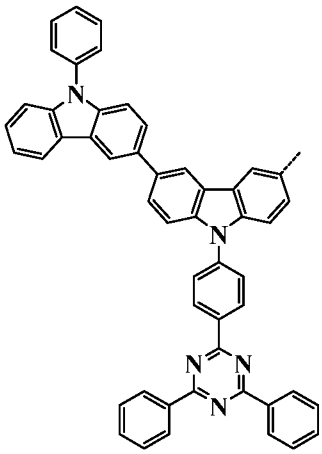
5-18

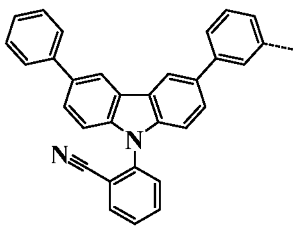
5-19
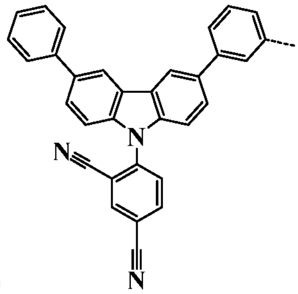
5-20
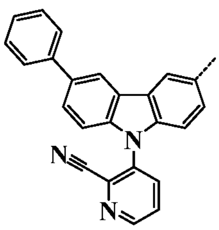
5-21

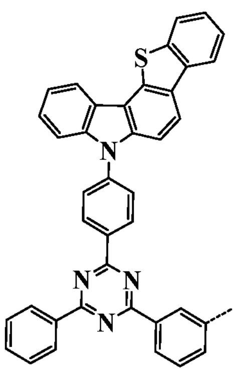
5-22
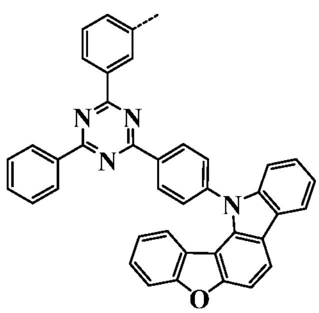
5-23
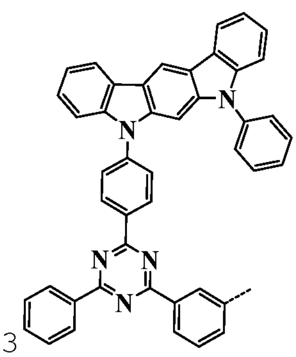
5-24

[C8]

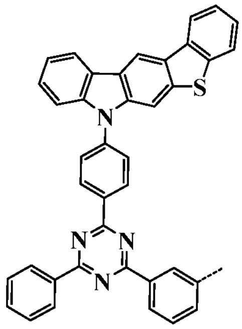
5-25
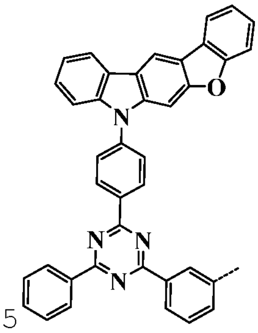
5-26
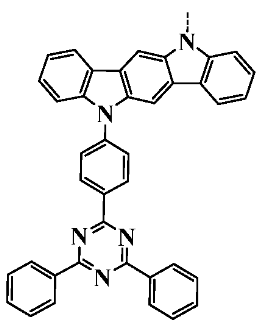
5-27

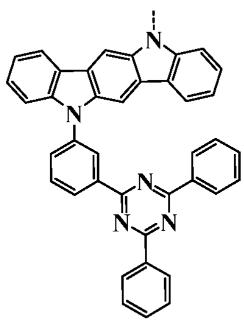
5-28
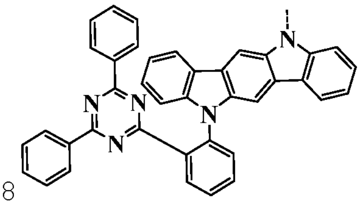
5-29

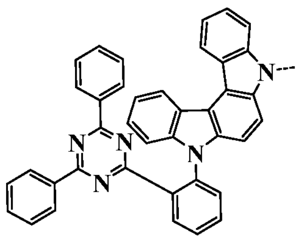
5-30
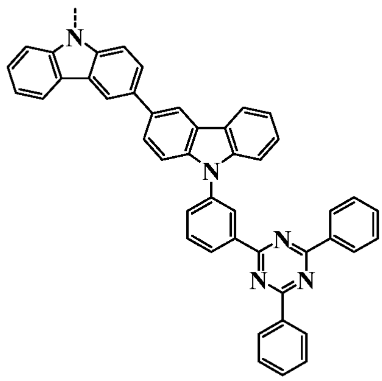
5-31

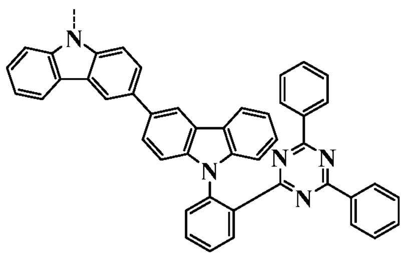
5-32
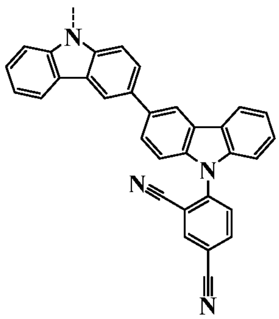
5-33

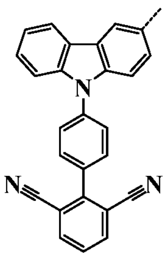
5-34

[C9]

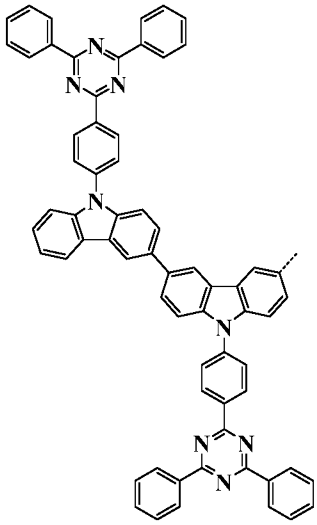
6-1

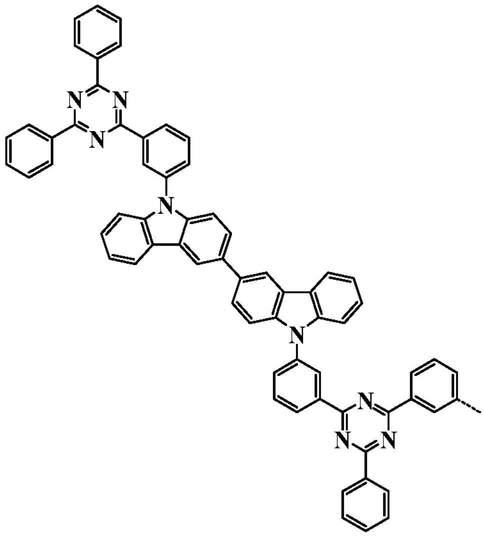
6-2

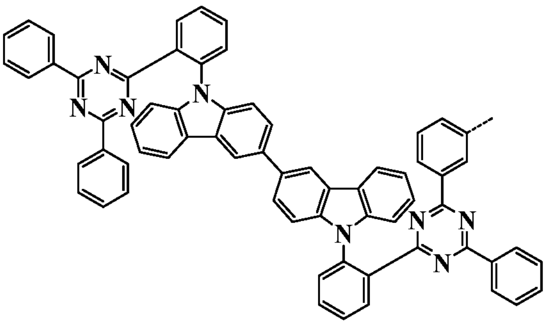
6-3

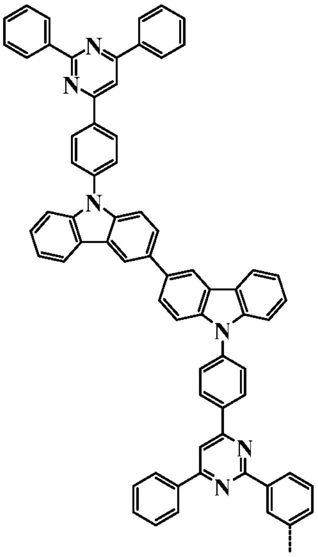
6-4

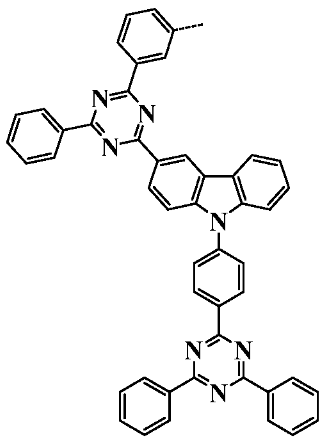
6-5

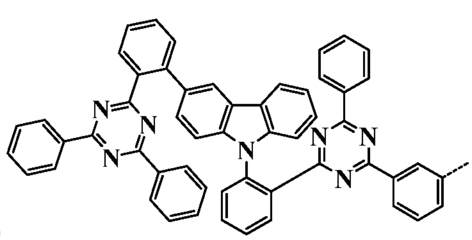
6-6

[C10]

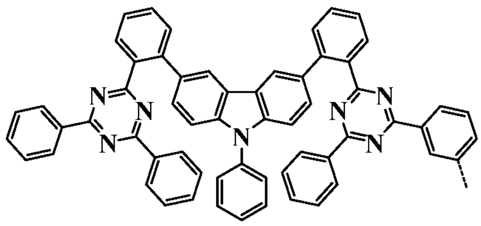

6-7

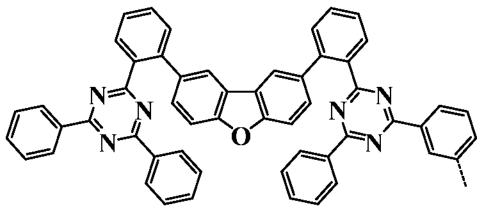

6-8

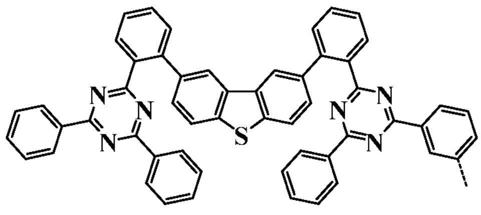

6-9

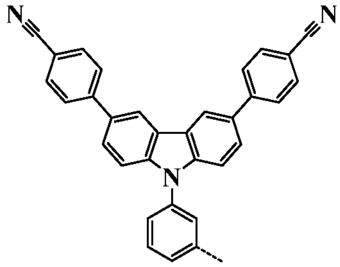

6-10

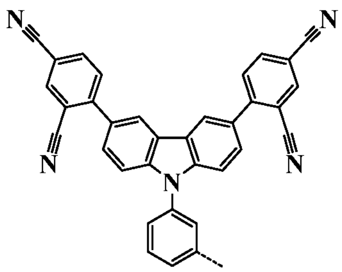

6-11

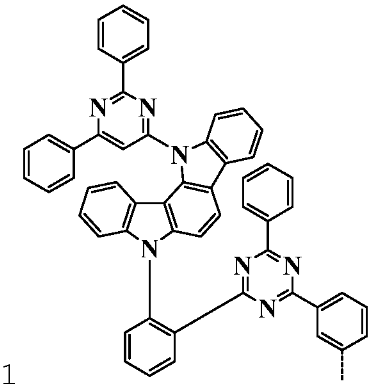

6-12

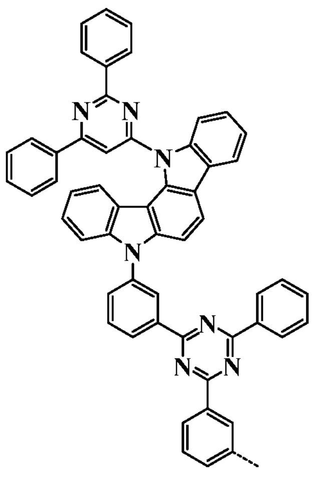

6-13

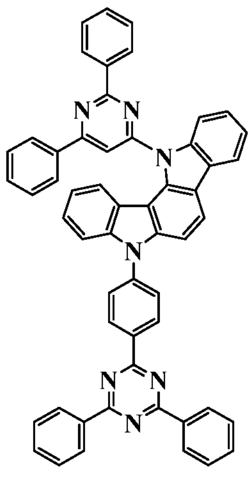

6-14

[C11]

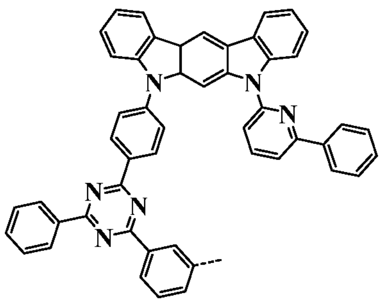

6-15

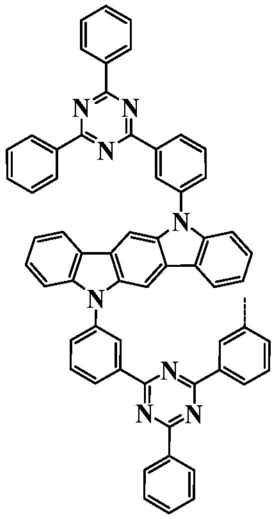

6-16

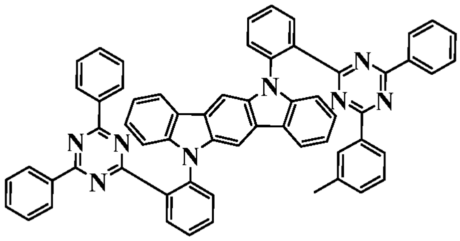

6-17

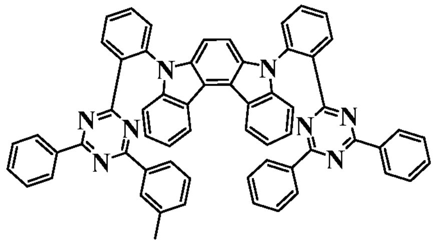

6-18

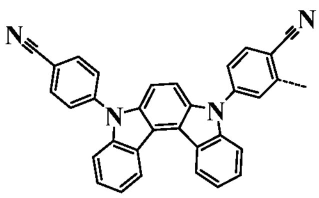

6-19

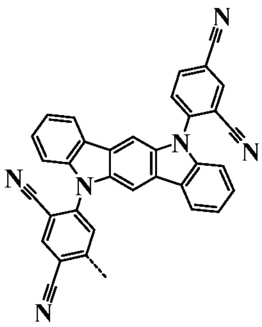

6-20

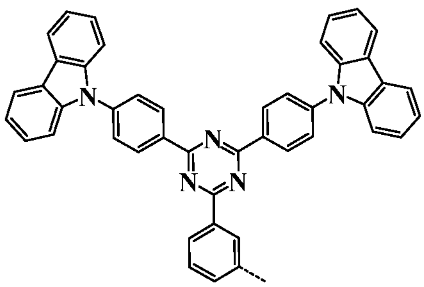

7-1

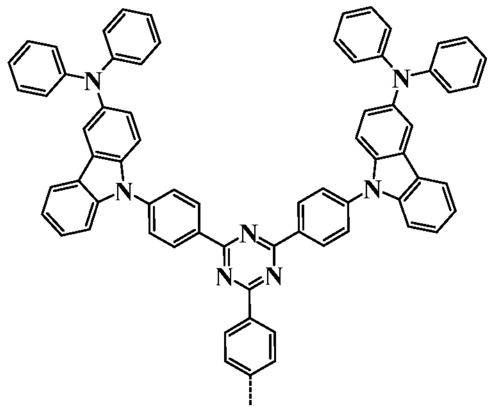

7-2

[C12]

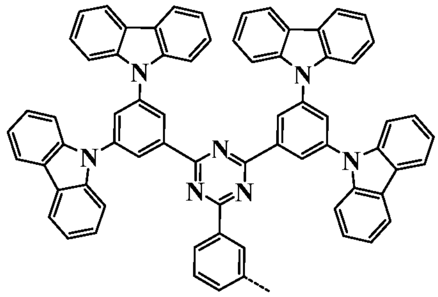
7-3

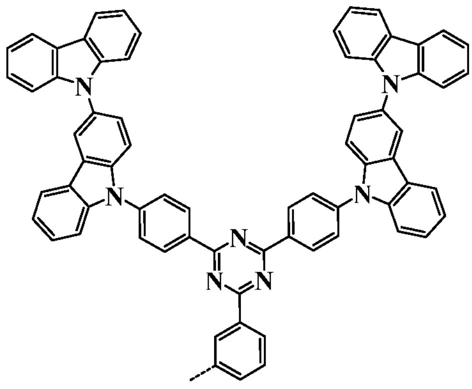
7-4

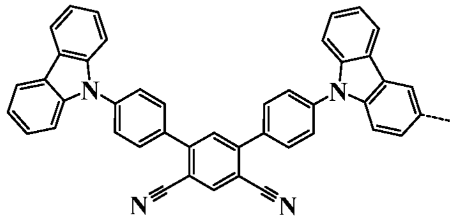
7-5

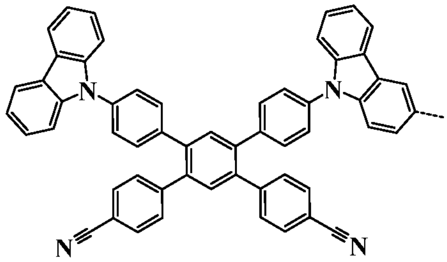
7-6

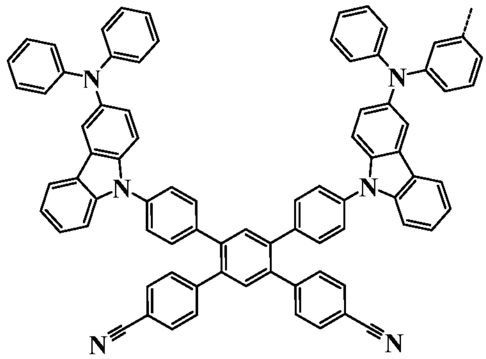
7-7

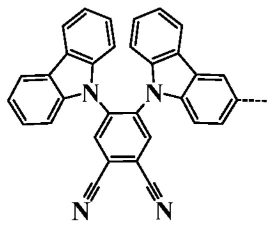
7-8

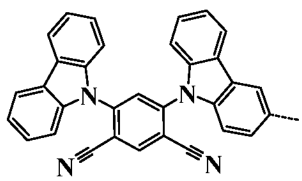
7-9

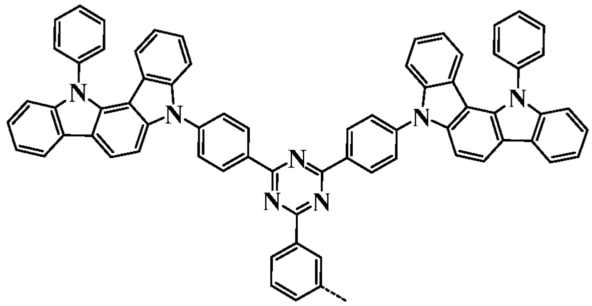
7-10

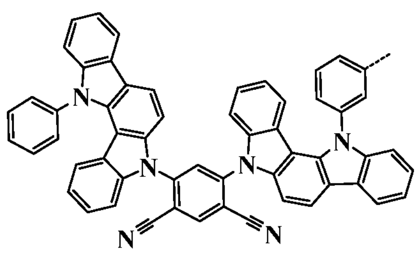
7-11

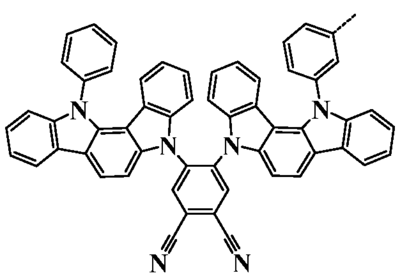
7-12

[C13]

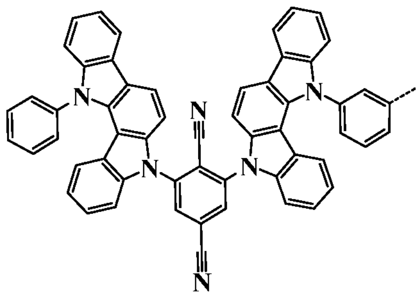
7-13
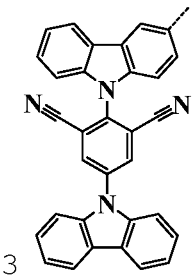
7-14

Examples of the group generated from the structures represented by Formulas (8) and (9) are shown below.

[C14]

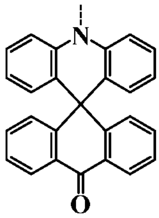
8-1
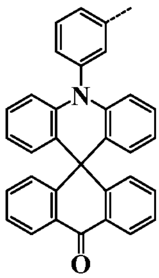
8-2
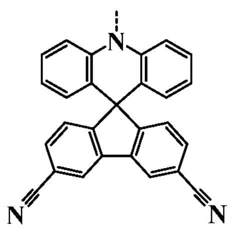
8-3
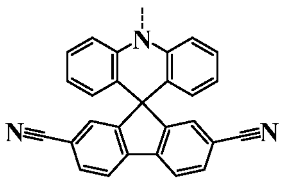
8-4

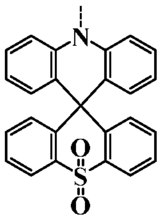
8-5
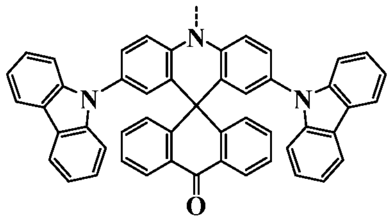
8-6

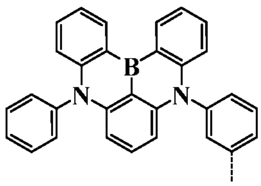
9-1
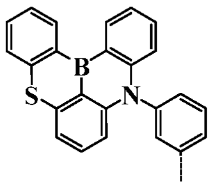
9-2
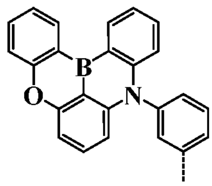
9-3

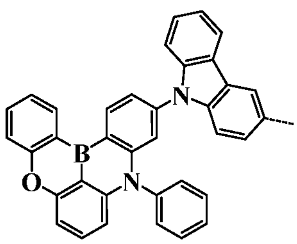
9-4
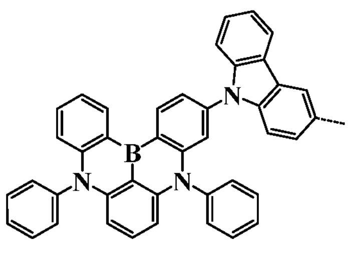
9-5
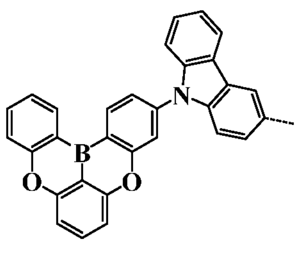
9-6

The polymer for organic electroluminescent devices of the present invention may be a polymer having only one kind of the above-exemplified partial structures in a repeating unit, or may be a polymer having a plurality of different partial structures of the above-exemplified examples. Furthermore, a repeating unit having a partial structure other than the above-exemplified partial structures may be included.

The polymer for organic electroluminescent devices of the present invention may have a substituent R in the

polyphenylene skeleton of the main chain, but when the polymer has the substituent R, the substituent R is preferably substituted at the ortho position with respect to linking of the main chain from the viewpoint of inhibiting the spread of the orbit and increasing T1. Preferred substitution positions of the substituent R are shown below, but linking structures and substitution positions of the substituent R are not limited thereto.

[C15]

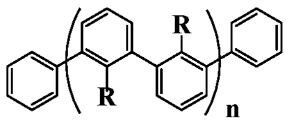
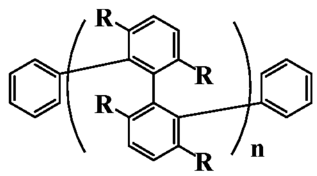
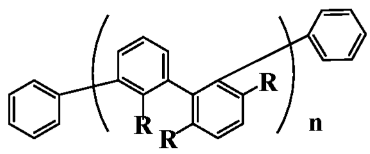

Examples of the polymer for organic electroluminescent devices of the present invention are shown below.

[C16]

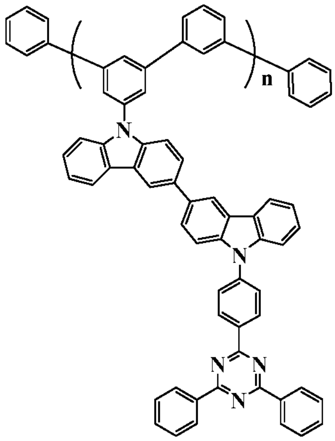

P-1

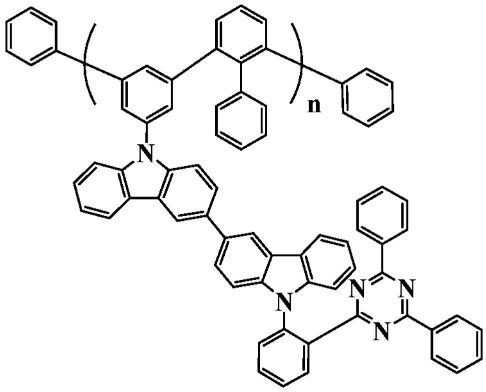

P-2

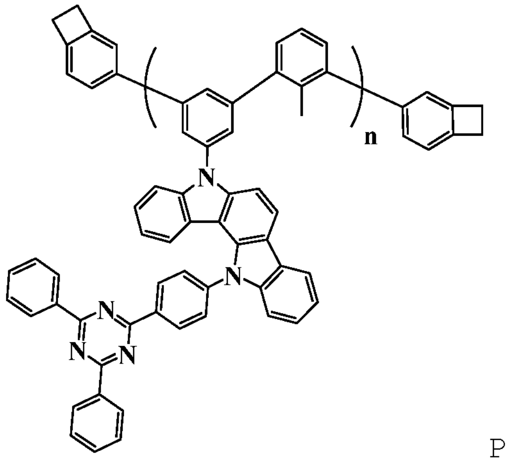

P-3

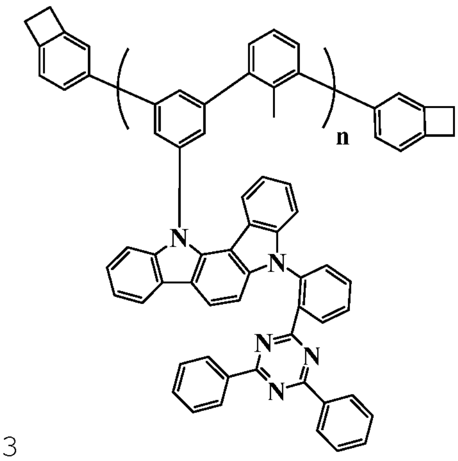

P-4

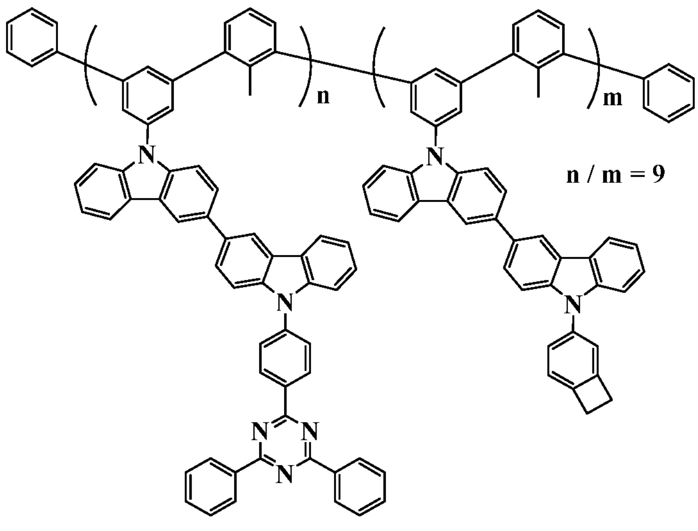

n / m = 9

P-5

[C17]

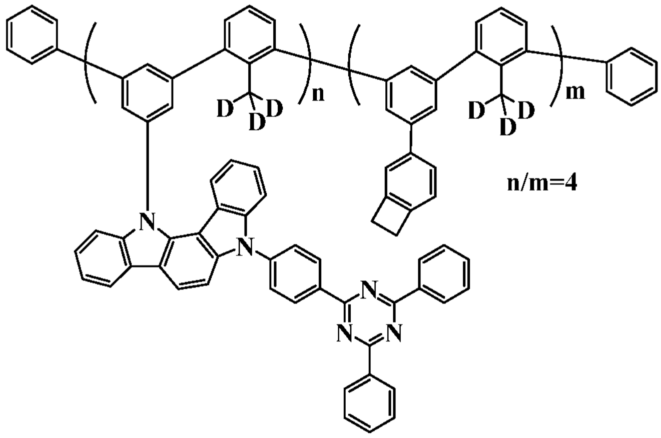


P-6

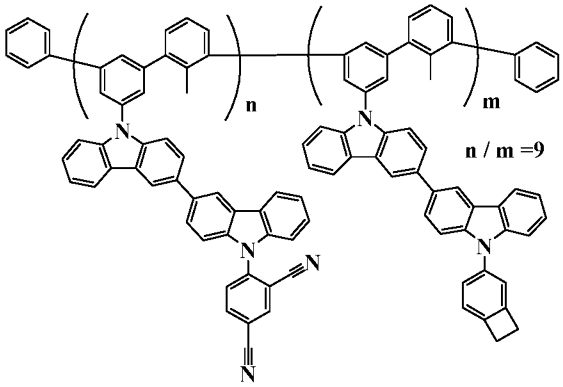


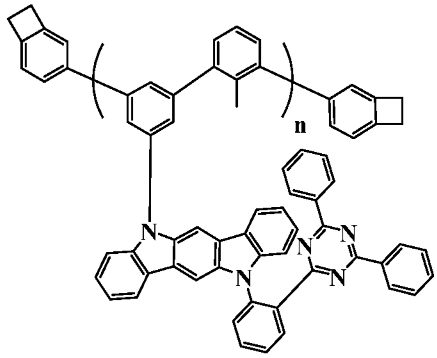

P-8

P-7

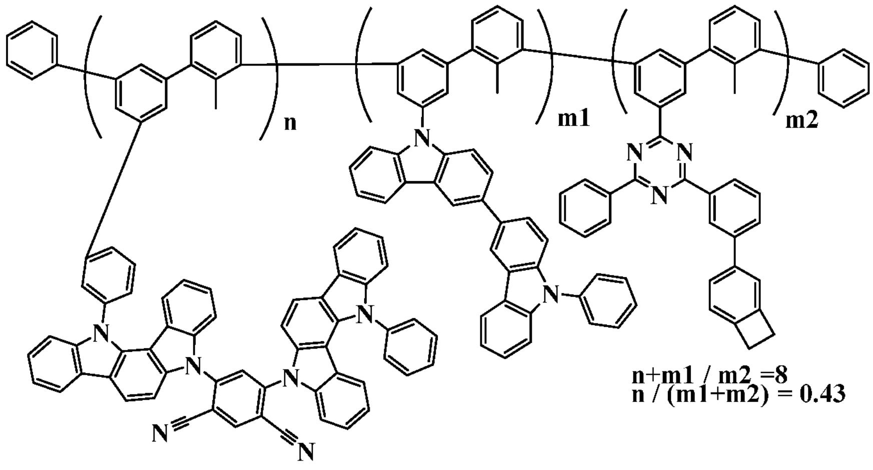


P-9

[C18]

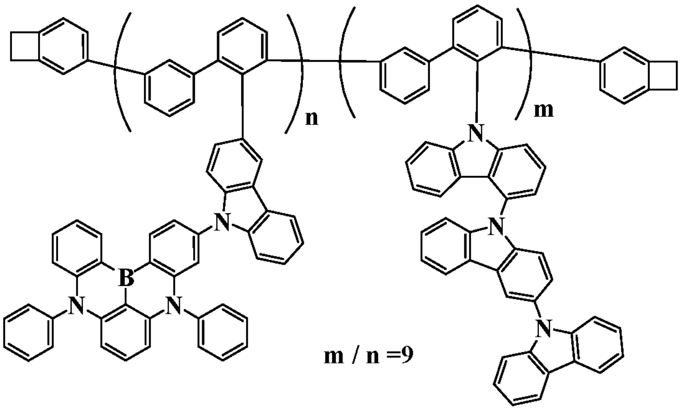

m / n =9

P-10

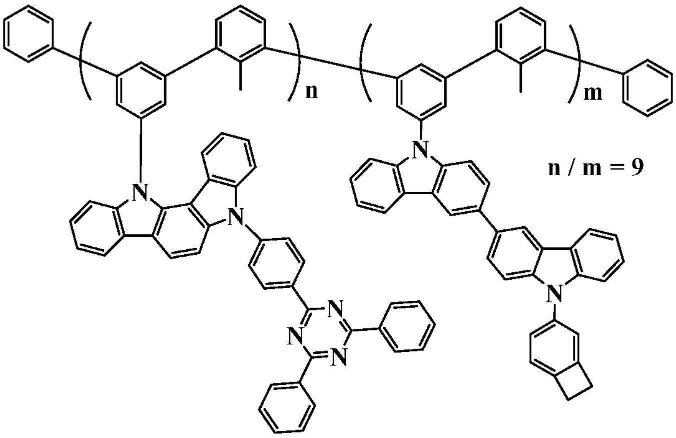

n / m = 9

P-11

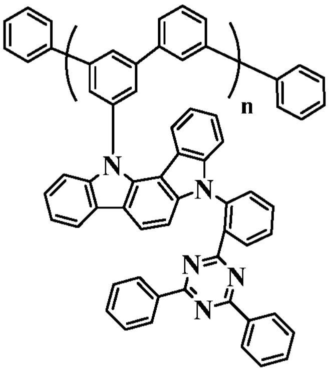

P-12

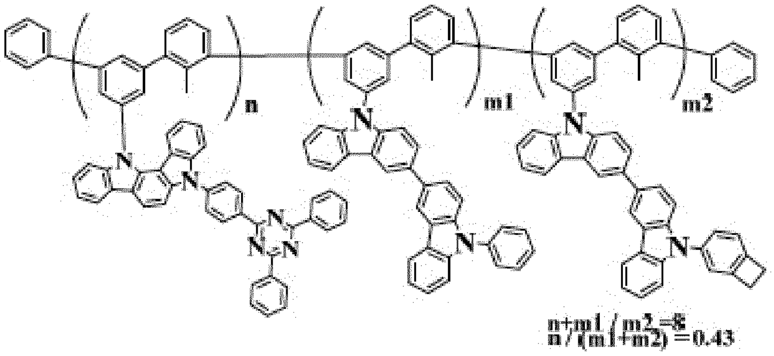

n+m1 / m2 =8
n / (m1+m2) = 0.43

P-13

Application examples of the polymer for organic electroluminescent devices of the present invention are shown below, but are not limited to these usage aspects.

The polymer for organic electroluminescent devices of the present invention is dissolved in a general organic solvent, and particularly, the solubility in toluene at 40°C is preferably 0.5 wt% or more, and more preferably 1 wt% or more.

The polymer for organic electroluminescent devices of the present invention can be contained in at least one layer selected from a light-emitting layer, a hole injection layer, a hole transport layer, an electron transport layer, an electron injection layer, a hole blocking layer, an electron blocking layer, an exciton blocking layer, and charge generating layer, and can be preferably used in a light-emitting layer, a hole transport layer, an electron transport layer, an electron injection layer, a hole blocking layer, an electron blocking layer, and an exciton blocking layer, and is more preferably contained in a light-emitting layer.

The polymer for organic electroluminescent devices of the present invention can be used alone as a material for organic electroluminescent devices, but functions thereof can be further improved or lacking characteristics can be supplemented by using a plurality of the compounds for organic electroluminescent devices of the present invention or by using as a material for organic electroluminescent devices by mixing with other compounds. Preferred compounds that can be used by being mixed with the compound for organic electroluminescent devices of the present invention is not particularly limited, but examples include a hole injection layer material, a hole transport layer material, an electron blocking layer material, a light-emitting layer material, a hole blocking layer material, an electron transport layer material, and a conductive high-molecular material which are used as a material for organic electroluminescent devices. The light-emitting layer material referred to herein includes a host material having hole transportability, electron transportability, and bipolar properties, and a light-emitting material such as a phosphorescent material, a fluorescent material and a thermally activated delayed fluorescent material.

The polymer for organic electroluminescent devices of the present invention can be a composition for organic electroluminescent devices by being dissolved or dispersed, in a solvent, alone or by mixing the polymer with another material, and is used as a material for organic electroluminescent devices.

A film-forming method of the material for organic electroluminescent devices of the present invention is not particularly limited, and among them, a printing method is exemplified as a preferred film-forming method. Specific examples of the printing method include, but are not limited to, a spin coating method, a bar coating method, a spray method, an ink jet method, and the like.

When the material for organic electroluminescent devices of the present invention is formed into a film by the printing method, after applying a solution (composition for organic electroluminescent devices), in which the material for organic electroluminescent devices of the present invention is dissolved or dispersed in a solvent, on a substrate, an organic layer can be formed by volatilizing the solvent by heating and drying. At this time, the solvent used is not particularly limited, but it is preferably one that uniformly disperses or dissolves the material and is hydrophobic. The solvent used may be one kind or may be a mixture of two or more kinds.

The solution in which the material for organic electroluminescent devices of the present invention is dissolved or dispersed in a solvent may contain one or two or more kinds of a material for organic electroluminescent devices as a compound other than the present invention, and may contain additives such as surface modifiers, dispersants, and radical trapping agents, and nanofillers in the range not impairing the characteristics.

Next, the structure of an device produced using the material of the present invention will be described with reference to the drawings, but the structure of the organic electroluminescent device of the present invention is not limited thereto.

Fig. 1 is a cross-sectional view showing a structure example of a general organic electroluminescent device used in the present invention, 1 represents a substrate, 2 represents an anode, 3 represents a hole injection layer, 4 represents a hole transport layer, 5 represents an electron blocking layer, 6 represents a light-emitting layer, 7 represents a hole blocking layer, 8 represents an electron transport layer, 9 represents an electron injection layer, and 10 represents an anode. The organic EL device of the present invention may have an exciton blocking layer adjacent to the light-emitting layer instead of the electron blocking layer or the hole blocking layer. The exciton blocking layer can be inserted into either on the side of the cathode or the side of the anode of the light-emitting layer and can be inserted into both sides at the same time. Furthermore, a plurality of light-emitting layers having different wavelengths may be provided. The organic electroluminescent device of the present invention has the anode, the light-emitting layer, and the cathode as essential layers, but it is desirable that the organic electroluminescent device have a hole injection transport layer and an electron injection transport layer in addition to the essential layers, and additionally have a hole blocking layer between the light-emitting layer and the electron injection transport layer and have an electron blocking layer between the light-emitting layer and the hole injection transport layer. Here, the hole injection transport layer refers to either or both of the hole injection layer and the hole transport layer, and the electron injection transport layer refers to either or both of the electron injection layer and the electron transport layer.

A structure reverse to that of Fig. 1, that is, a structure in which a cathode 10, an electron injection layer 9, an electron transport layer 8, a hole blocking layer 7, a light-emitting layer 6, an electron blocking layer 5, a hole transport

layer 4, a hole injection layer 3, and an anode 2 are laminated on a substrate 1 in that order, can be used, and in this case also, layers can be added or omitted as necessary.

-Substrate-

The organic electroluminescent device of the present invention is preferably supported on a substrate. This substrate is not particularly limited, and for example, it may be an inorganic material such as glass, quartz, alumina, and SUS, or may be an organic material such as polyimide, PEN, PEEK, and PET. The substrate may be in the form of a hard plate or in the form of a flexible film.

-Anode-

Regarding an anode material for the organic electroluminescent device, a material of a metal having a large work function (4 eV or more), an alloy, an electrically conductive compound or a mixture thereof is preferably used. Specific examples of such an electrode material include a metal such as Au, and a conductive transparent material such as CuI, indium tin oxide (ITO), $SnO_2$, and ZnO. In addition, an amorphous material such as IDIXO ($In_2O_3$-ZnO) which can create a transparent conductive film may be used. Regarding the anode, such an electrode material may be used to form a thin film by a vapor-deposition or sputtering method, and a desired shape pattern may be formed by a photolithographic method, or if pattern accuracy is not particularly required (about 100 μm or more), a pattern may be formed via a mask with a desired shape when the electrode material is vapor-deposited or sputtered. Alternatively, when a coatable substance such as the organic conductive compound is used, a wet film formation method such as a printing method and a coating method can be used. When light is emitted from the anode, it is desirable that the transmittance be larger than 10% and the sheet resistance for the anode be preferably several hundreds of Ω/sq or less. The film thickness depends on the material, and it is generally 10 to 1,000 nm, and preferably selected in a range of 10 to 200 nm.

-Cathode-

On the other hand, regarding a cathode material, a material of a metal having a small work function (4 eV or less) (referred to as an electron injection metal), an alloy, an electrically conductive compound, or a mixture thereof is used. Specific examples of such an electrode material include aluminum, sodium, a sodium-potassium alloy, magnesium, lithium, a magnesium/copper mixture, a magnesium/silver mixture, a magnesium/aluminum mixture, a magnesium/indium mixture, an aluminum/aluminum oxide ($Al_2O_3$) mixture, indium, a lithium/aluminum mixture, and a rare earth metal. Among these, in consideration of electron injectability and durability with respect to oxidation and the like, a mixture of an electron injection metal and a second metal which is a stable metal having a larger work function value, for example, a magnesium/silver mixture, a magnesium/aluminum mixture, a magnesium/indium mixture, an aluminum/aluminum oxide ($Al_2O_3$) mixture, a lithium/aluminum mixture, aluminum, and the like are suitable. The cathode can be produced by forming a thin film by a method such as vapor-depositing or sputtering of such a cathode material. In addition, a sheet resistance for the cathode is preferably several hundreds of Ω/sq or less, and the film thickness is generally 10 nm to 5 μm, and preferably selected in a range of 50 to 200 nm. Here, in order to transmit emitted light, if either the anode or the cathode of the organic electroluminescent device is transparent or translucent, light emission brightness is improved, which is advantageous.

In addition, after the metal with a film thickness of 1 to 20 nm is formed on the cathode, when a conductive transparent material exemplified in the description of the anode is formed thereon, a transparent or translucent cathode can be produced and by applying this, it is possible to produce an device in which both the anode and the cathode have transparency.

-Light-emitting layer-

The light-emitting layer is a layer that emits light after excitons are generated when holes and electrons injected from the anode and the cathode, respectively, are recombined, and the light-emitting layer contains a light-emitting dopant material and a host material.

The polymer for organic electroluminescent devices of the present invention is suitably used as a light-emitting material or a host material that assists light emission. Since the polymer for organic electroluminescent devices of the present invention has TADF characteristics, high luminous efficiency can be expected when used as a light-emitting material.

Furthermore, also when used as a host material, high luminous efficiency can be expected by combination with a fluorescent material having a lower S1 than that of the polymer for organic electroluminescent devices of the present invention or a phosphorescent material having a lower T1 than that of the polymer for organic electroluminescent devices

of the present invention.

When used as a light-emitting material or a host material, the polymer for organic electroluminescent devices of the present invention may be used alone or may be used in combination of a plurality of polymers. Furthermore, one or a plurality of kinds of light-emitting materials or host materials other than the material of the present invention may be used in combination.

The host material that can be used is not particularly limited, but is preferably a compound having a hole transporting ability and an electron transporting ability, preventing a long wavelength of light emission, and having a high glass transition temperature.

Such other host materials are known from numerous patent literatures and the like and can be selected from them. Specific examples of the host material are not particularly limited, and examples thereof include high-molecular compounds such as indole derivatives, carbazole derivatives, indolocarbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidene compounds, porphyrin compounds, anthraquinodimethane derivatives, anthrone derivatives, diphenylquinone derivatives, thiopyran dioxide derivatives, heterocyclic tetracarboxylic acid anhydrides such as naphthalene perylene, phthalocyanine derivatives, metal complexes and metal phthalocyanines of 8-quinolinol derivatives, various metal complexes typified by metal complexes of benzoxazole and benzothiazole derivatives, polysilane compounds, poly(N-vinylcarbazole) derivatives, aniline copolymers, thiophene oligomers, polythiophene derivatives, polyphenylene vinylene derivatives, and polyfluorene derivatives.

When the polymer for organic electroluminescent devices of the present invention is used as a light-emitting layer material, a film forming method thereof is preferably a printing method in which, after forming a solution by dissolving the polymer in a solvent, the solution is applied on a hole injection transport layer or an electron blocking layer and dried. A light-emitting layer can be formed by this method.

When the polymer for organic electroluminescent devices of the present invention is used as a light-emitting layer material and vapor-deposited to form an organic layer, other host materials and dopants may be vapor-deposited from different vapor deposition sources together with the material of the present invention, or a plurality of host materials and dopants can be vapor-deposited from one vapor deposition source at the same time by previously mixing before vapor deposition to obtain a premixture.

When the polymer for organic electroluminescent devices of the present invention is used as a light-emitting layer material and a light-emitting layer is formed by the printing method, a solution to be applied may contain a host material, a dopant material, an additive, and the like in addition to the polymer for organic electroluminescent devices of the present invention. When forming a film by application using the solution containing the polymer for organic electroluminescent devices of the present invention, a material used for the hole injection transport layer as the base material thereof preferably has a low solubility in the solvent used for the light-emitting layer solution or is preferably insolubilized by crosslinking or polymerization.

The light-emitting dopant material is not particularly limited as long as it is a light-emitting material, and specific examples thereof include a fluorescence-emitting dopant, a phosphorescent dopant, a delayed fluorescence-emitting dopant, an f-f transition light-emitting dopant, and the like. Furthermore, only one kind of these light-emitting dopants may be contained, or two or more kinds of the dopants may be contained.

As a phosphorescent dopant, one including an organometallic complex containing at least one metal selected from among ruthenium, rhodium, palladium, silver, rhenium, osmium, iridium, platinum, and gold is preferred. Specifically, iridium complexes described in J. Am. Chem. Soc. 2001, 123, 4304 and Japanese Translation of PCT Application No. 2013-53051 are preferably used, but the present invention is not limited thereto. Furthermore, the content of the phosphorescent dopant material is preferably 0.1 to 30 wt% and more preferably 1 to 20 wt% with respect to the host material.

The phosphorescent dopant material is not particularly limited, and specific examples thereof include the following.

[C19]

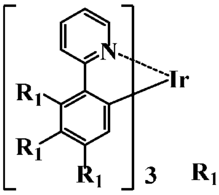 $R_1$=H, $CH_3$, $CF_3$, F , 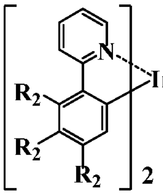 $R_2$=H, F , 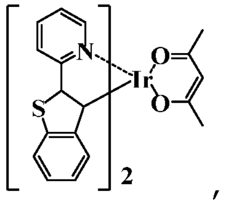 ,

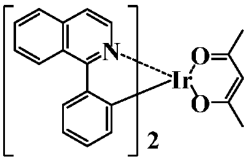 , 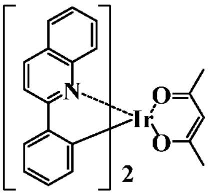 , 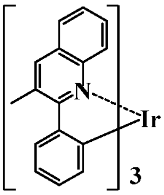 , 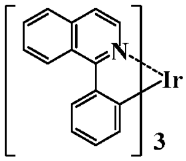 ,

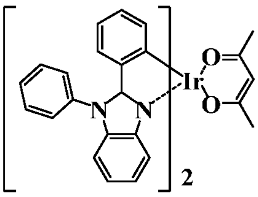 , 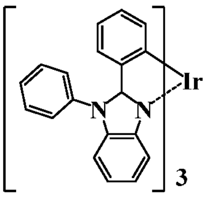 , 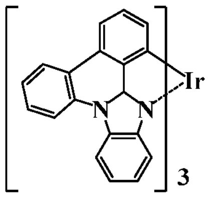 , 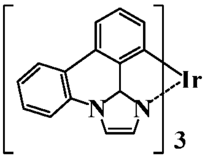 ,

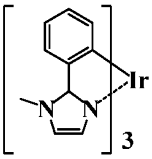 , 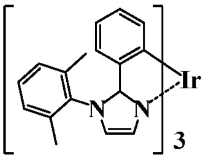 , 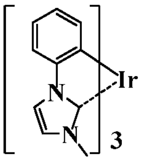 , 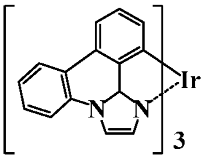 , 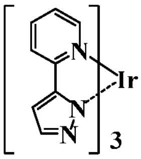 ,

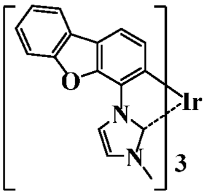 , 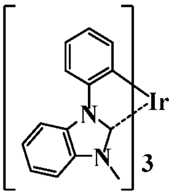 , 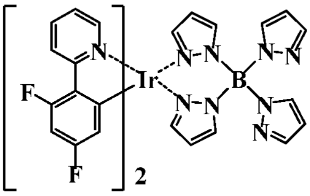 , 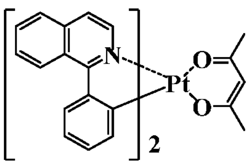 ,

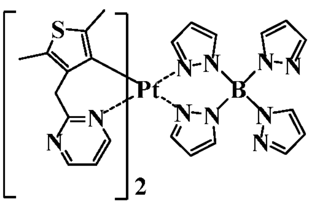 , 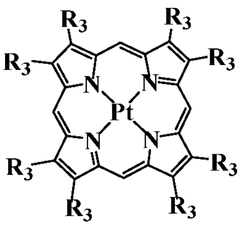 $R_3$=$CH_3$, $CH_2CH_3$ ,

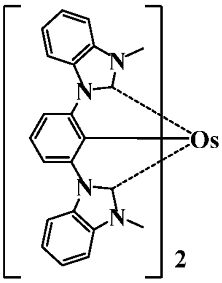

When a fluorescence-emitting dopant is used, the fluorescence-emitting dopant is not particularly limited. Examples thereof include benzoxazole derivatives, benzothiazole derivatives, benzimidazole derivative, styrylbenzene derivatives, polyphenyl derivatives, diphenyl butadiene derivatives, tetraphenyl butadiene derivatives, naphthalimide derivative, coumarin derivatives, fused aromatic compound, perinone derivatives, oxadiazole derivative, oxazine derivatives, aldazine derivatives, pyrrolidine derivatives, cyclopentadiene derivatives, bis-styryl anthracene derivatives, quinacridone derivatives, pyrrolopyridine derivatives, thiadiazolopyridine derivatives, styrylamine derivatives, diketopyrrolopyrrole derivatives, aromatic dimethylidine compounds, metal complexes of 8-quinolinol derivatives, metal complexes of pyromethene derivatives, rare earth complexes, various metal complexes represented by transition metal complexes, polymer compounds such as polythiophene, polyphenylene, and polyphenylene vinylene, and organosilane derivatives. Preferable examples thereof include fused aromatic derivatives, styryl derivatives, diketopyrrolopyrrole derivatives, oxazine derivatives, pyromethene metal complexes, transition metal complexes, and lanthanoid complexes. More preferable examples thereof include naphthalene, pyrene, chrysene, triphenylene, benzo[c]phenanthrene, benzo[a]anthracene, pentacene, perylene, fluoranthene, acenaphthofluoranthene, dibenzo[a,j]anthracene, dibenzo[a,h]anthracene, benzo[a]naphthalene, hexacene, naphtho[2,1-f]isoquinoline, $\alpha$-naphthaphenanthridine, phenanthrooxazole, quinolino[6,5-f]quinoline, and benzothiophanthrene. These may have an alkyl group, an aryl group, an aromatic heterocyclic group, or a diarylamino group as a substituent. Furthermore, the content of the fluorescence-emitting dopant material is preferably 0.1% to 20% by weight and more preferably 1% to 10% by weight with respect to the host material.

When a thermally activated delayed fluorescence-emitting dopant is used, the thermally activated delayed fluorescence-emitting dopant is not particularly limited. Examples thereof include metal complexes such as a tin complex and a copper complex, indolocarbazole derivatives described in WO 2011/070963, cyanbenzene derivatives described in Nature 2012, 492, 234, carbazole derivatives, phenazine derivatives described in Nature Photonics 2014, 8, 326, oxadiazole derivatives, triazole derivatives, sulfone derivatives, phenoxazine derivatives, and acridine derivatives. Furthermore, the content of the thermally activated delayed fluorescence-emitting dopant material is preferably 0.1% to 90% and more preferably 1% to 50% with respect to the host material.

The f-f transition light-emitting dopant may be one including an organometallic complex containing at least one metal selected from yttrium, lanthanum, cerium, praseodymium, neodymium, samarium, europium, gadolinium, terbium, dysprosium, erbium, thulium, and ytterbium. Specifically, europium complexes disclosed in WO 2012/150712 A and WO 2015/002295 A are preferably used, but the present invention is not limited thereto. Furthermore, the content of the f-f transition light-emitting dopant material is preferably 0.1 to 30 wt% and more preferably 0.5 to 20 wt% with respect to the host material.

-Injection layer-

The injection layer is a layer that is provided between an electrode and an organic layer in order to lower a driving voltage and improve light emission brightness, and includes a hole injection layer and an electron injection layer, and may be present between the anode and the light-emitting layer or the hole transport layer, and between the cathode and the light-emitting layer or the electron transport layer. The injection layer can be provided as necessary.

-Hole blocking layer-

The hole blocking layer has the function of an electron transport layer in a broad sense, is made of a hole blocking material that has a function of transporting electrons and has a significantly small ability to transport holes, and can improve a probability of recombining electrons and holes in the light-emitting layer by blocking holes while transporting electrons.

As the hole blocking layer, the material for organic electroluminescent devices of the present invention can be used, but a known hole blocking layer material can also be used.

-Electron blocking layer-

The electron blocking layer has a function of a hole transport layer in a broad sense and blocks electrons while transporting holes, and thus can improve a probability of recombining electrons and holes in the light-emitting layer.

As the electron blocking layer, the material for organic electroluminescent devices of the present invention can be used, but a known electron blocking layer material may be used, and a hole transport layer material to be described later can be used as necessary. The film thickness of the electron blocking layer is preferably 3 to 100 nm, and more preferably 5 to 30 nm.

-Exciton blocking layer-

The exciton blocking layer is a layer for blocking diffusion of excitons generated when holes and electrons are recombined in the light-emitting layer in a charge transport layer, and when this layer is inserted, excitons can be efficiently confined in the light-emitting layer, and the luminous efficiency of the device can be improved. The exciton blocking layer can be inserted between two adjacent light-emitting layers in an device in which two or more light-emitting layers are adjacent to each other.

Regarding the material of the exciton blocking layer, known exciton blocking layer materials can be used. Examples include 1,3-dicarbazolylbenzene (mCP) and bis(2-methyl-8-quinolinolato)-4-phenylphenolatoaluminium (III) (BAlq).

-Hole transport layer-

The hole transport layer is made of a hole transport material having a function of transporting holes, and a single hole transport layer or a plurality of hole transport layers can be provided.

The hole transport material has either hole injection or transport properties or electron barrier properties, and may be an organic material or an inorganic material. For the hole transport layer, the material for organic electroluminescent devices of the present invention can be used, but any one selected from conventionally known compounds may be used. Examples of the known hole transport material include porphyrin derivatives, arylamine derivatives, triazole derivatives, oxadiazole derivatives, imidazole derivatives, polyarylalkane derivatives, pyrazoline derivatives and pyrazolone derivatives, phenylenediamine derivatives, arylamine derivatives, amino-substituted chalcone derivatives, oxazole derivatives, styryl anthracene derivatives, fluorenone derivatives, hydrazone derivatives, stilbene derivatives, silazane derivatives, an aniline copolymer, and a conductive polymer oligomers, and particularly a thiophene oligomer. Porphyrin derivatives, arylamine derivatives, or styrylamine derivatives are preferably used. An arylamine compound is more preferably used.

-Electron transport layer-

The electron transport layer is made of a material having a function of transporting electrons, and a single electron transport layer or a plurality of electron transport layers can be provided.

The electron transport material (which may also be a hole blocking material) may have a function of transferring electrons injected from the cathode to the light-emitting layer. For the electron transport layer, any one selected from among conventionally known compounds can be used, and examples thereof include polycyclic aromatic derivatives such as naphthalene, anthracene, and phenanthroline, tris(8-quinolinolato)aluminum (III) derivatives, phosphine oxide derivatives, nitro-substituted fluorene derivatives, diphenylquinone derivatives, thiopyrandioxide derivatives, carbodiimide, freorenylidene methane derivatives, anthraquinodimethane and anthrone derivatives, bipyridine derivatives, quinoline derivatives, oxadiazole derivatives, benzimidazole derivatives, benzothiazole derivatives, and indolocarbazole derivatives. In addition, a polymer material in which such a material is introduced into a polymer chain or such a material is used for a main chain of a polymer can be used.

## Examples

While the present invention will be described below in more detail with reference to examples, the present invention is not limited to these examples, and can be implemented in various forms without departing from the scope and spirit thereof.

S1 and T1 of the partial structures A and B were performed using the quantum chemical calculation program Gaussian 16 manufactured by Gaussian, Inc. in the United States. In the calculation, using density-functional theory (DFT), calculated values of S1 and T1 were calculated by timedependent density-functional theory (TD-DFT) regarding a structure optimized by using B3LYP as the functional and 6-31G* as the basis function.

Measurement of molecular weight and molecular weight distribution of polymer

Measurement of the molecular weight and molecular weight distribution of the synthesized polymer was performed using GPC (manufactured by TOSOH CORPORATION, HLC-8120 GPC) with a solvent: tetrahydrofuran (THF) and at a flow rate: 1.0 ml/min and a column temperature: 40°C. The molecular weight of the polymer was calculated as a polystyrene-equivalent molecular weight using a calibration curve of monodisperse polystyrene.

Evaluation of polymer solubility

The solubility of the synthesized polymer was evaluated by the following method. Mixing with toluene was performed so that the concentration was 0.5 wt%, and ultrasound treatment was performed at room temperature for 30 minutes. After leaving the solution to stand at room temperature for 1 hour, it was visually confirmed. The determination was ∘ when there was no precipitation of an insoluble material in the solution, and was × when there was an insoluble material.

Hereinafter, examples of synthesis by polycondensation will be described, but the polymerization method is not limited to these, and other polymerization methods such as a radical polymerization method and an ionic polymerization method may be used.

Example 1

Polymer P-4 was synthesized via Intermediates A, B, and C and Polymerization intermediates A and B.

(Synthesis of Intermediate A)

[C20]

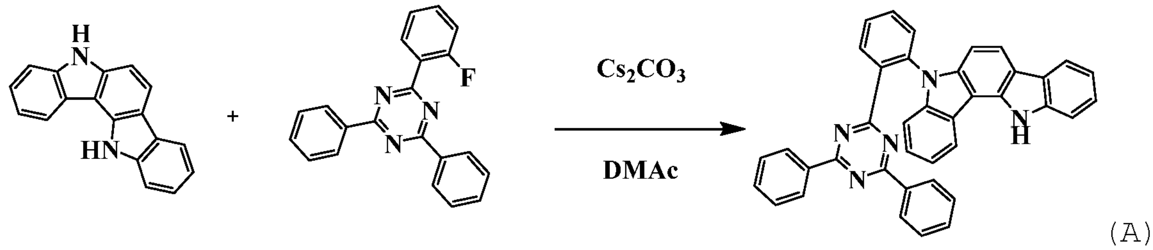


(A)

Under a nitrogen atmosphere, 5.13 g (20.0 mmol) of 5,12-dihydroindolo[3,2-a]carbazole, 7.21 g (22.0 mmol) of 2-(2-fluorophenyl)-4,6-diphenyl-1,3,5-triazine, 32.61 g (100.1 mmol) of cesium carbonate, and 100 ml of N-N-dimethylacetamide (dehydrated) were added and stirred. Thereafter, heating was performed to 140°C, and stirring was performed for 24 hours. After cooling the reaction solution to room temperature, the inorganic substance was filtered. The filtrate was dried under reduced pressure and then purified by column chromatography to obtain 8.1 g (14.4 mmol, yield 71.8%) of Intermediate A of the pale yellow powder.

(Synthesis of Intermediate B)

[C21]

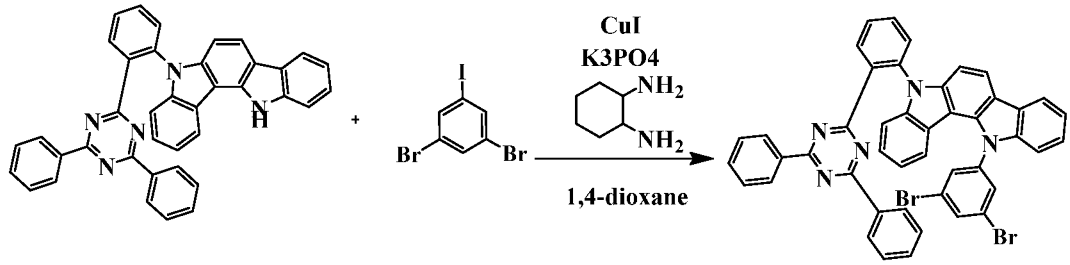


(B)

Under a nitrogen atmosphere, 2.00 g (3.5 mmol) of Intermediate A, 1.54 g (4.3 mmol) of 3,5-dibromoiodobenzene, 0.02 g (0.1 mmol) of copper iodide, 3.77 g (17.7 mmol) of tripotassium phosphate, 0.16 g (1.4 mmol) of trans-1,2-cyclohexanediamine, and 10 ml of 1,4-dioxane were added and stirred. Thereafter, heating was performed to 130°C, and stirring was performed for 72 hours. After cooling the reaction solution to room temperature, the inorganic substance

was filtered. The filtrate was dried under reduced pressure and then purified by column chromatography to obtain 2.10 g (2.6 mmol, yield 74.2%) of Intermediate B of the pale yellow powder.

(Synthesis of Intermediate C)

[C22]

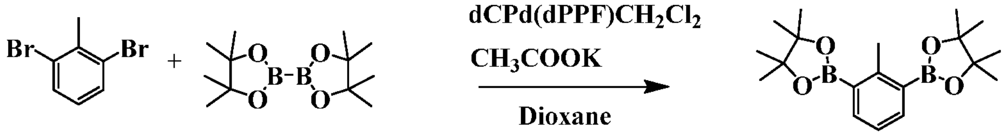


(C)

Under a nitrogen atmosphere, 5.00 g (20.0 mmol) of 2,6-dibromotoluene, 12.19 g (48.0 mmol) of bispinacolatodiboron, 0.98 g (1.2 mmol) of [1,1'-bis(diphenylphosphino)ferrocene]palladium(II)dichloride dichloromethane adduct, 11.78 g (120.0 mmol) of potassium acetate, and 100 ml of dioxane were added and stirred. Thereafter, heating was performed to 130°C, and stirring was performed for 6 hours. The reaction solution was cooled to room temperature, water was added and the mixture was stirred, and then the organic layer was recovered. Magnesium sulfate and activated carbon were added, and after stirring, the solid substance was filtered. After distilling off the solvent under reduced pressure to concentrate the filtrate, recrystallization was performed with hexane to obtain 4.78 g (13.9 mmol, yield 69.4%) of Intermediate C of the light brown powder.

(Synthesis of Polymer P-4)

[C23]

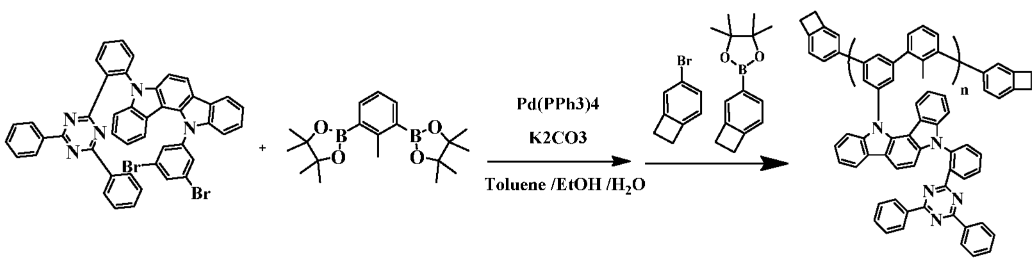


(P-4)

Procedure 1) 2.00 g (2.5 mmol) of Intermediate B, 0.86 g (2.5 mmol) of Intermediate C, 0.09 g (0.08 mmol) of tetrakistriphenylphosphine palladium, 1.73 g (12.5 mmol) of potassium carbonate, and toluene 5 ml/ethanol 2.5 ml/water 2.5 ml were added and stirred. Thereafter, heating was performed to 90°C, and stirring was performed for 4 hours. After cooling the reaction solution to room temperature, the sediment and the organic layer were recovered. Ethanol was added to the organic layer, and the precipitated precipitate was recovered together with the sediment and purified by column chromatography to obtain Polymerization Intermediate A of the light yellow powder.

Procedure 2) The same operation was performed using Polymerization Intermediate A instead of Intermediate B in the above-mentioned procedure 1 and using 3-bromobenzocyclobutene instead of Intermediate C to obtain Polymerization Intermediate B of the pale yellow powder.

Procedure 3) The same operation was performed using Polymerization Intermediate B instead of Polymerization Intermediate A in the above-mentioned procedure 2 and using benzocyclobutene boronic acid pinacol ester instead of 3-bromobenzocyclobutene to obtain 1.5 g of Polymer P-4 of the colorless powder. Polymer P-4 obtained had a weight-average molecular weight Mw = 11710, a number average molecular weight Mn = 3450, and Mw/Mn = 3.39.

Fig. 2 shows the emission spectrum from a thin film of Polymer P-4 when the thin film is irradiated with light of 340 nm using a xenon lamp at room temperature.

Example 2

Polymer P-13 was synthesized via Intermediates D, E, F, G, and H and Polymerization Intermediates C and D.

(Synthesis of Intermediate D)

[C24]

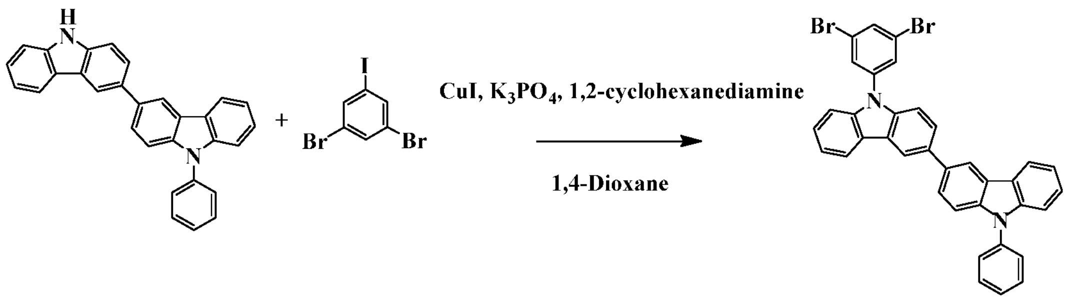


(D)

Under a nitrogen atmosphere, 8.15 g (20.0 mmol) of 9-phenyl-9H,9'H-3,3'-bicarbazole, 9.38 g (25.9 mmol) of 3,5-dibromoiodobenzene, 0.11 g (0.6 mmol) of copper iodide, 21.17 g (99.8 mmol) of tripotassium phosphate, 0.91 g (8.0 mmol) of trans-1,2-cyclohexanediamine, and 80 ml of 1,4-dioxane were added and stirred. Thereafter, heating was performed to 120°C, and stirring was performed for 24 hours. After cooling the reaction solution to room temperature, the inorganic substance was filtered. The filtrate was dried under reduced pressure and then purified by column chromatography to obtain 9.60 g (14.9 mmol, yield 74.9%) of Intermediate D of the pale yellow powder.

(Synthesis of Intermediate E)

[C25]

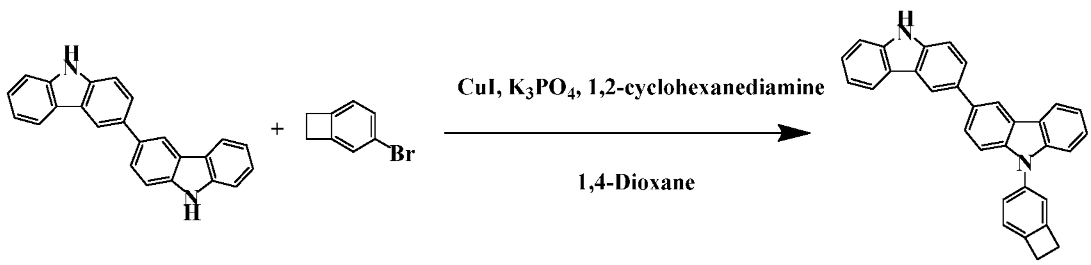


(E)

Under a nitrogen atmosphere, 3.33 g (10.0 mmol) of bicarbazole, 1.83 g (10.0 mmol) of 4-bromobenzocyclobutene, 0.057 g (0.30 mmol) of copper iodide, 10.63 g (50.1 mmol) of tripotassium phosphate, 0.46 g (4.01 mmol) of trans-1,2-cyclohexanediamine, and 30 ml of 1,4-dioxane were added and stirred. Thereafter, heating was performed to 130°C, and stirring was performed for 24 hours. After cooling the reaction solution to room temperature, the inorganic substance was filtered. The filtrate was dried under reduced pressure and then purified by column chromatography to obtain 3.57 g (8.22 mmol, yield 82.0%) of Intermediate E of the white powder.

(Synthesis of Intermediate F)

[C26]

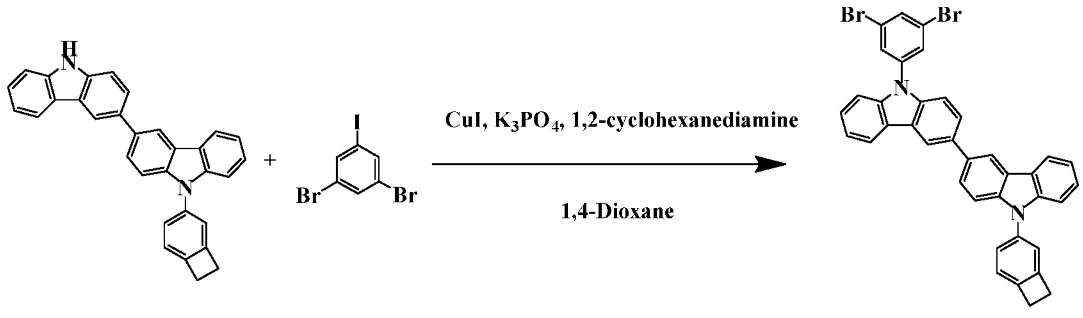


(F)

Under a nitrogen atmosphere, 2.17 g (5.0 mmol) of Intermediate E, 1.81 g (5.0 mmol) of 1,3-dibromo-5-iodobenzene, 0.029 g (0.15 mmol) of copper iodide, 5.30 g (25.0 mmol) of tripotassium phosphate, 0.23 g (2.0 mmol) of trans-1,2-cyclohexanediamine, and 20 ml of 1,4-dioxane were added and stirred. Thereafter, heating was performed to 110°C, and stirring was performed for 24 hours. After cooling the reaction solution to room temperature, the inorganic substance was filtered. The filtrate was dried under reduced pressure and then purified by column chromatography to obtain 2.55 g (3.81 mmol, yield 76.4%) of Intermediate F of the pale yellow powder.

(Synthesis of Intermediate G)

[C27]

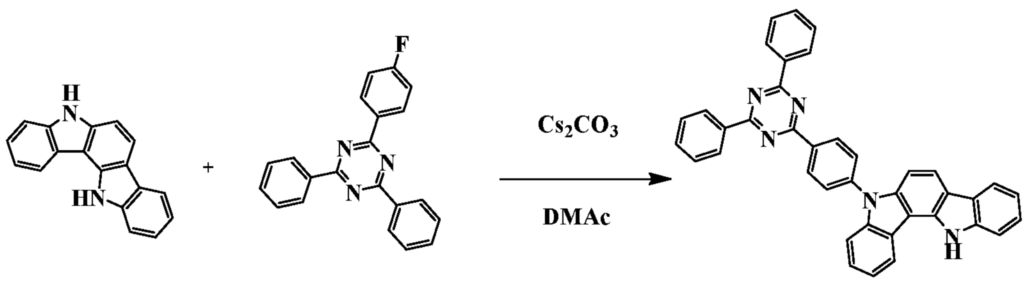


(G)

Under a nitrogen atmosphere, 10.00 g (39.0 mmol) of 5,12-dihydroindolo[3,2-a]carbazole, 14.05 g (42.9 mmol) of 2-(4-fluorophenyl)-4,6-diphenyl-1,3,5-triazine, 63.56 g (195.1 mmol) of cesium carbonate, and 200 ml of N-N-dimethylacetamide (dehydrated) were added and stirred. Thereafter, heating was performed to 140°C, and stirring was performed for 24 hours. After cooling the reaction solution to room temperature, the inorganic substance was filtered. The filtrate was dried under reduced pressure and then purified by column chromatography to obtain 18.8 g (33.4 mmol, yield 85.5%) of Intermediate G of the pale yellow powder.

(Synthesis of Intermediate H)

[C28]

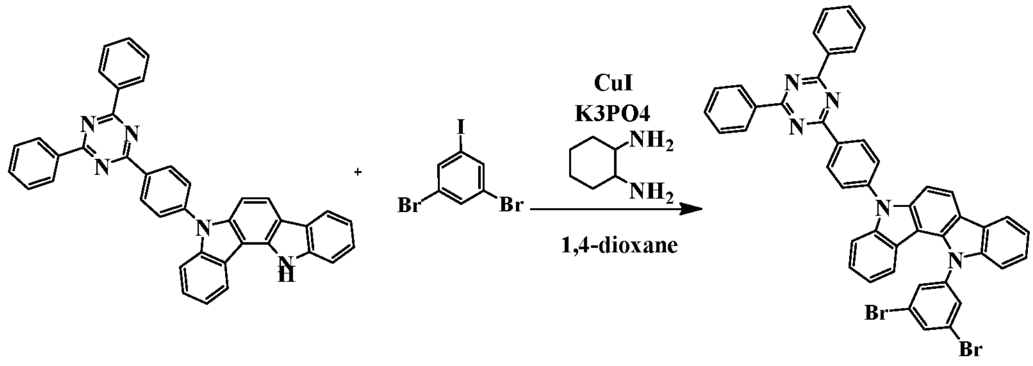


(H)

Under a nitrogen atmosphere, 5.65 g (10.0 mmol) of Intermediate G, 4.35 g (12.0 mmol) of 3,5-dibromoiodobenzene, 0.57 g (0.3 mmol) of copper iodide, 10.64 g (50.1 mmol) of tripotassium phosphate, 0.46 g (4.0 mmol) of trans-1,2-cyclohexanediamine, and 30 ml of 1,4-dioxane were added and stirred. Thereafter, heating was performed to 130°C, and stirring was performed for 72 hours. After cooling the reaction solution to room temperature, the inorganic substance was filtered. The filtrate was dried under reduced pressure and then purified by column chromatography to obtain 5.6 g (7.0 mmol, yield 70.1%) of Intermediate H of the pale yellow powder.

(Synthesis of Polymer P-13)

[C29]

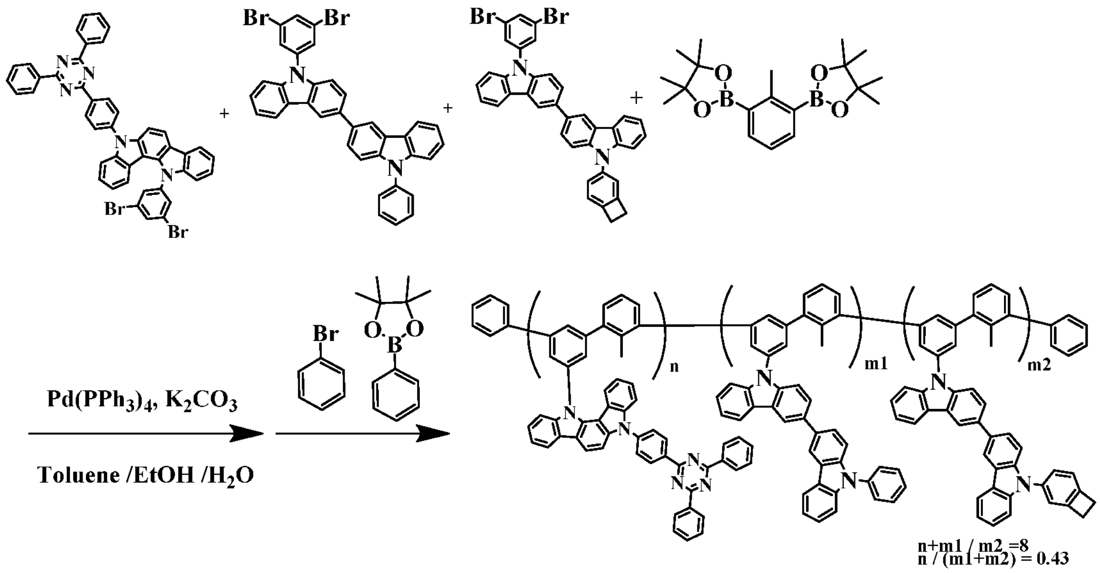


Procedure 1) 1.65 g (5.0 mmol) of Intermediate C, 0.67 g (1.0 mmol) of Intermediate D, 1.61 g (2.5 mmol) of Intermediate F, 1.20 g (1.5 mmol) of Intermediate H, 0.17 g (0.15 mmol) of tetrakistriphenylphosphine palladium, 2.07 g (15.0 mmol) of potassium carbonate, and toluene 30 ml/ethanol 15 ml/water 15 ml were added and stirred. Thereafter, heating was performed to 90°C, and stirring was performed for 24 hours. After cooling the reaction solution to room temperature, the sediment and the organic layer were recovered. Ethanol was added to the organic layer, and the precipitated precipitate was recovered together with the sediment and purified by column chromatography to obtain Polymerization Intermediate C of the light yellow powder.

Procedure 2) The same operation was performed using Polymerization Intermediate C instead of Intermediates D, F, and H in the above-mentioned procedure 1 and using iodobenzene instead of Intermediate C to obtain Polymerization

Intermediate D of the pale yellow powder.

Procedure 3) The same operation was performed using Polymerization Intermediate D instead of Polymerization Intermediate C in the above-mentioned procedure 2 and using phenylboronic acid instead of iodobenzene to obtain 1.2 g of Polymer P-13 of the colorless powder. Polymer P-13 obtained had a weight-average molecular weight Mw = 19110, a number average molecular weight Mn = 4930, and Mw/Mn = 3.88.

Examples 3 to 5 and Comparative Examples 1 and 2

The following polymers were synthesized by a synthesis method similar to the above-mentioned method.

[C30]

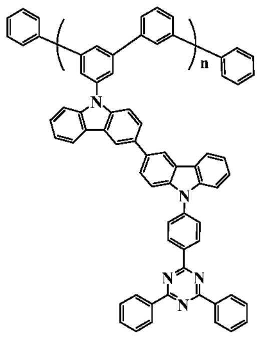
P-1

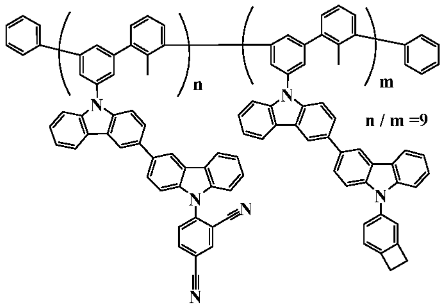
P-7

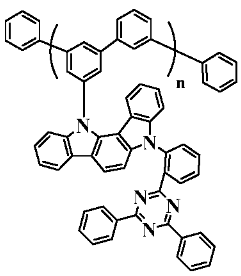
P-12

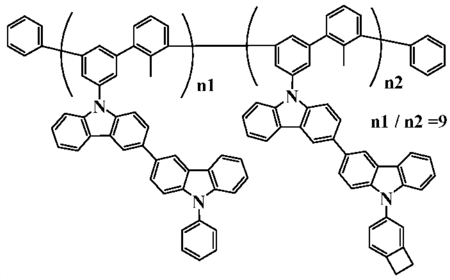
2-5

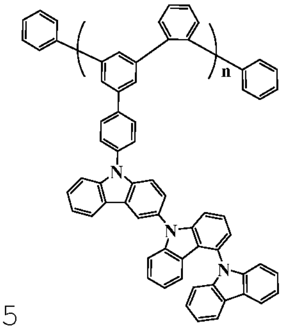
2-6

For the polymers obtained in the above-mentioned examples, and 2-5 and 2-6 synthesized for comparison, ΔE (eV) calculated from the following formula was calculated.

$$\Delta E\ (A) = S1(A) - T1(A)$$

$$\Delta E\ (B) = S1(B) - T1(B)$$

The calculation results are shown in Table 1, and the GPC measurement results and the solubility evaluation results are shown in Table 2. The case in which ΔE satisfies 0.5 eV or less is defined as ΔE (A), and the case in which ΔE exceeds 0.5 eV is defined as ΔE (B).

[Table 1]

| | Polymer | ΔE (A) | ΔE (B) |
|---|---|---|---|
| Ex. 1 | P-4 | 0.03 | - |
| Ex. 2 | P-13 | 0.19 | 0.73 |
| Ex. 3 | P-1 | 0.20 | - |
| Ex. 4 | P-7 | 0.17 | 0.73 |

(continued)

| | Polymer | ΔE (A) | ΔE (B) |
|---|---|---|---|
| Ex. 5 | P-12 | 0.03 | - |
| Comp. Ex. 1 | 2-5 | - | 0.73/0.72 |
| Comp. Ex. 2 | 2-6 | - | 0.51 |

[Table 2]

| | Polymer | Mw | Mn | Mw/Mn | Solubility |
|---|---|---|---|---|---|
| Ex. 6 | P-4 | 11710 | 3450 | 3.39 | ∘ |
| Ex. 7 | P-13 | 19110 | 4930 | 3.88 | ∘ |
| Ex. 8 | P-1 | 6521 | 3210 | 2.03 | ∘ |
| Ex. 9 | P-7 | 4547 | 2771 | 1.64 | ∘ |
| Ex. 10 | P-12 | 23115 | 5348 | 4.32 | ∘ |
| Comp. Ex. 3 | 2-5 | 15433 | 3842 | 4.02 | ∘ |
| Comp. Ex. 4 | 2-6 | 21238 | 5455 | 3.89 | ∘ |

The compound numbers described in the following examples and comparative examples correspond to the numbers assigned to the above-mentioned exemplary polymers and the numbers assigned to the following compounds.

[C31]

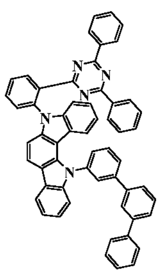
2-1

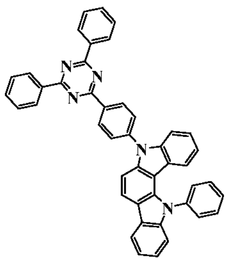
2-2

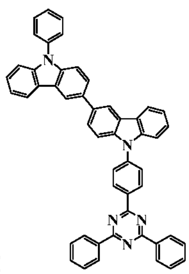
2-3

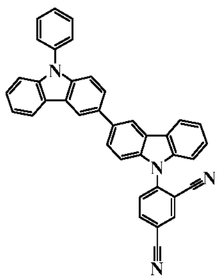
2-4

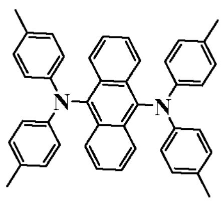
2-7

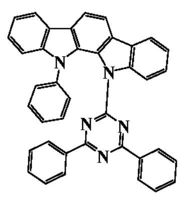
2-8

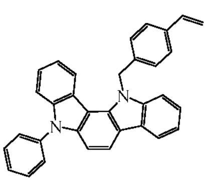
HT-1

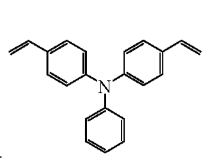
BBPPA

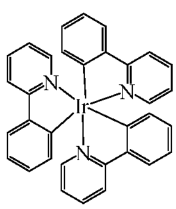
Ir(ppy)$_3$

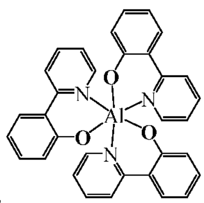
Alq$_3$

Examples 11 and 12 and Comparative Example 5

Optical evaluation was performed using Polymers P-4 and P-13, and Polymer 2-5 for comparison. The polymer

was dissolved in a solvent (trial concentration: $10^{-5}$ [mol/l], solvent: toluene) to perform measurement of PL quantum yield before performing nitrogen substitution and after performing nitrogen substitution using an absolute PL quantum yield measurement device (C11347-01) manufactured by Hamamatsu Photonics K.K. The results are shown in Table 3.

[Table 3]

| | Polymer | Quantum yield Before nitrogen substitution | Quantum yield After nitrogen substitution |
|---|---|---|---|
| Ex. 11 | P-4 | 15% | 79% |
| Ex. 12 | P-13 | 50% | 55% |
| Comp. Ex. 5 | 2-5 | 40% | 40% |

In Examples 11 and 12, quantum yields were improved by nitrogen substitution, which is a tendency peculiar to materials with delayed fluorescent properties, and it was found that a high quantum yield by thermally activated delayed fluorescence emission can be expected in the polymer of the present invention.

Example 13

Optical evaluation was performed using Polymer P-4. Polymer P-4, and Polymer 2-6 as a host were mixed at a weight ratio of 3:7 in a quartz substrate washed with a solvent and treated with UV ozone, the mixture was dissolved in toluene to prepare a 2 wt% solution, and a film was formed by a spin coating method. The quantum yield of the produced substrate was measured using an absolute PL quantum yield measurement device (C11347-01) manufactured by Hamamatsu Photonics K.K. The maximum peak wavelength of the obtained emission spectrum was time-resolved to express the emission time (emission lifetime) of immediate fluorescence by $\tau$p and express the emission time (emission lifetime) of delayed fluorescence by $\tau$d. Furthermore, the maximum emission wavelength of the emission spectrum was expressed by $\lambda$max. The results are shown in Table 4.

Examples 14 and 15 and Comparative Examples 6, 7, and 8

Evaluation of Polymers P-13 and P-1, and Compounds 2-1, 2-2, and 2-3 for comparison were also performed in the same manner as in Example 13.

[Table 4]

| | Compound or polymer | Host | Quantum yield | $\tau$p | $\tau$d | $\lambda$max |
|---|---|---|---|---|---|---|
| Ex. 13 | P-4 | 2-6 | 87% | 33 ns | 2.6 $\mu$s | 495 nm |
| Ex. 14 | P-13 | 2-6 | 91% | 17 ns | 11 $\mu$s | 485 nm |
| Ex. 15 | P-1 | 2-6 | 94% | 9 ns | 19 $\mu$s | 484 nm |
| Comp. Ex. 6 | 2-1 | 2-6 | 74% | 39 ns | 3.1 $\mu$s | 504 nm |
| Comp. Ex. 7 | 2-2 | 2-6 | 91% | 14 ns | 10 $\mu$s | 489 nm |
| Comp. Ex. 8 | 2-3 | 2-6 | 95% | 10 ns | 20 $\mu$s | 490 nm |

In a case of polymerization, there are usually problems such as wavelength elongation of emission wavelength, reduced efficiency, and non-exhibition of TADF properties, but the polymer of the present invention has film forming properties by application without impairing efficiency and emission wavelength, and it was found that the polymer of the present invention is a material exhibiting a high quantum yield by thermally activated delayed fluorescence characteristics.

Example 16

Poly(3,4-ethylenedioxythiophene)/polystyrene sulfonate (PEDOT/PSS): (manufactured by H.C. Starck Tantalum and Niobium GmbH, trade name: Clevios PCH8000) was formed as a hole injection layer by the film thickness of 25 nm on an ITO coated glass substrate washed with a solvent, treated with UV ozone, and having the thickness of 150 nm. Next, a mixture mixed at a ratio of HT-1:BBPPA = 5:5 (molar ratio) was dissolved in toluene to prepare a 0.4 wt% solution, and a 10 nm film was formed by a spin coating method. In addition, heating was performed on a hot plate at 150°C for 1 hour under anaerobic conditions to perform curing. This thermosetting film is a film having a crosslinked

structure and is insoluble in a solvent. This thermosetting film is a hole transport layer (HTL). Next, Polymer 2-5 was dissolved in toluene to prepare a 0.4 wt% solution, and a 10 nm film was formed by a spin coating method. In addition, the solvent was removed on a hot plate at 230°C for 1 hour under anaerobic conditions, and heating was performed. This heated product is an electron blocking layer (EBL) and is insoluble in a solvent. Then, using Polymer 2-6 as a host and Polymer P-4 as a light-emitting dopant, a toluene solution (1.0 wt%) was prepared so that the weight ratio of the host:dopant was 70:30, and after forming a film of 40 nm as a light-emitting layer by a spin coating method, heating was performed on a hot plate at 230°C for 1 hour under anaerobic conditions to perform curing. Thereafter, using a vacuum vapor deposition apparatus, a film was formed with $Alq_3$ of 35 nm and LiF/Al as a cathode with a film thickness of 170 nm, and this device was sealed in a glove box to produce an organic electroluminescent device.

Comparative Example 7

An organic EL device was produced in the same manner except that Polymer 2-6 was used as a host and Compound 2-1 was used as a light-emitting dopant in Example 16.

When the organic EL devices produced in the above-mentioned examples and comparative examples were connected to an external power supply and supplied with a DC voltage, the emission spectrum derived from the dopant was observed. At this time, the external quantum efficiency (EQE) was 9.1% and the maximum emission wavelength ($\lambda$max) was 498 nm at the drive current of 5 mA/$cm^2$ in Comparative Example 7. Table 5 shows the results of comparison with Example 16.

[Table 5]

| | Host polymer | Dopant | $\lambda$max (nm) | EQE (%) |
|---|---|---|---|---|
| Ex. 16 | 2-5 | P-4 | 494 | 11.2 |
| Comp. Ex. 7 | 2-6 | 2-1 | 498 | 9.1 |

It was found that the polymer of the present invention exhibits high luminous efficiency as a dopant material.

Example 17

An organic EL device was produced in the same manner except that Polymer P-13 was used as a host and $Ir(ppy)_3$ was used as a light-emitting dopant in Example 16.

Comparative Example 8

An organic EL device was produced in the same manner except that, in Example 16, a material in which Polymer 2-6 as a host and Compound 2-8 were mixed at the ratio of 7:3 was used, and $Ir(ppy)_3$ was used as a light-emitting dopant, and evaluation was performed. The results are shown in Table 6.

[Table 6]

| | Host | Dopant | $\lambda$max (nm) | EQE (%) |
|---|---|---|---|---|
| Ex. 17 | P-13 | $Ir(ppy)_3$ | 530 | 11.8 |
| Comp. Ex. 8 | 2-6/2-8 | $Ir(ppy)_3$ | 530 | 10.7 |

It was found that the polymer of the present invention exhibits high luminous efficiency as a phosphorescent host material.

Example 18

An organic EL device was produced in the same manner except that, in Example 16, Polymer P-4 was used as a host and Compound 2-7 was used as a light-emitting dopant, and a film was formed so that the weight ratio of the host: dopant was 99:1.

Comparative Example 9

An organic EL device was produced in the same manner except that, in Example 16, Polymer 2-6 was used

as a host and Compound 2-7 was used as a light-emitting dopant, and a film was formed so that the weight ratio of the host:the dopant was 99:1. Table 7 shows the results of evaluating the device in the same method as in Example 16.

[Table 7]

| | Host polymer | Dopant | λmax (nm) | EQE (%) |
|---|---|---|---|---|
| Ex. 18 | P-4 | 2-7 | 525 | 7.4 |
| Comp. Ex. 9 | 2-6 | 2-7 | 525 | 3.4 |

It was found that the polymer of the present invention exhibits high luminous efficiency as a fluorescent host material.

Based on the above results, it was found that when the polymer for organic electroluminescent devices of the present invention is used as an organic EL material, formation of a laminated film by application becomes possible, and an device showing highly efficient luminous characteristics can be produced.

[Industrial Applicability]

The organic electroluminescent device using the polymer for organic electroluminescent devices of the present invention shows high luminous efficiency and high driving stability.

[Reference Signs List]

1 Substrate
2 Anode
3 Hole injection layer
4 Hole transport layer
5 Electron blocking layer
6 Light-emitting layer
7 Hole blocking layer
8 Electron transport layer
9 Electron injection layer
10 Cathode

**Claims**

**1.** A polymer for organic electroluminescent devices, wherein

the polymer for organic electroluminescent devices has a polyphenylene structure in a main chain, and contains a structural unit represented by General Formula (1) as a repeating unit,
the structural units may be the same as or different from each other for each repeating unit, and
a weight-average molecular weight is 500 or more and 500000 or less,

[C1]

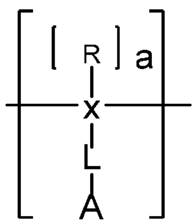

(1)

where x represents a phenylene group bonded at an arbitrary position or a linked phenylene group in which 2 to 6 phenylene groups are linked at an arbitrary position,

L's each independently represent a single bond, a substituted or unsubstituted aromatic hydrocarbon group having 6 to 24 carbon atoms, or a substituted or unsubstituted aromatic heterocyclic group having 3 to 17 carbon atoms,
A's are each independently a substituted or unsubstituted aromatic hydrocarbon group having 6 to 30 carbon atoms, an aromatic heterocyclic group having 3 to 24 carbon atoms, or a linked aromatic group in which 2 to 6 of these groups are linked, and satisfy Formula (2),
substituents when L and A have a substituent are each independently a group selected from deuterium, a halogen, a cyano group, a nitro group, an alkyl group having 1 to 20 carbon atoms, an aralkyl group having 7 to 38 carbon atoms, an alkenyl group having 2 to 20 carbon atoms, an alkynyl group having 2 to 20 carbon atoms, a dialkylamino group having 2 to 40 carbon atoms, a diarylamino group having 12 to 44 carbon atoms, a diaralkylamino group having 14 to 76 carbon atoms, an acyl group having 2 to 20 carbon atoms, an acyloxy group having 2 to 20 carbon atoms, an alkoxy group having 1 to 20 carbon atoms, an alkoxycarbonyl group having 2 to 20 carbon atoms, an alkoxycarbonyloxy group having 2 to 20 carbon atoms, and an alkylsulfonyl group having 1 to 20 carbon atoms;

$$S1(A) - T1(A) \leq 0.50 \text{ (eV)} \qquad (2)$$

S1(A): lowest excited singlet energy (eV) of partial structure A
T1(A): lowest excited triplet energy (eV) of partial structure A
where the partial structure A represents A-L-Ph in which x to which a substituent A-L- is bonded is substituted with a phenyl group (Ph),
R's each independently represent deuterium, a halogen, a cyano group, a nitro group, an alkyl group having 1 to 20 carbon atoms, an aralkyl group having 7 to 38 carbon atoms, an alkenyl group having 2 to 20 carbon atoms, an alkynyl group having 2 to 20 carbon atoms, a dialkylamino group having 2 to 40 carbon atoms, a diarylamino group having 12 to 44 carbon atoms, a diaralkylamino group having 14 to 76 carbon atoms, an acyl group having 2 to 20 carbon atoms, an acyloxy group having 2 to 20 carbon atoms, an alkoxy group having 1 to 20 carbon atoms, an alkoxycarbonyl group having 2 to 20 carbon atoms, an alkoxycarbonyloxy group having 2 to 20 carbon atoms, an alkylsulfonyl group having 1 to 20 carbon atoms, an aromatic hydrocarbon group having 6 to 18 carbon atoms, an aromatic heterocyclic group having 3 to 18 carbon atoms, or a linked aromatic group in which a plurality of these aromatic rings are linked, and when these groups have a hydrogen atom, the hydrogen atom may be substituted with deuterium or a halogen, and
a's each independently indicate an integer of 0 to 3.

**2.** The polymer for organic electroluminescent devices according to claim 1, wherein

the polymer for organic electroluminescent devices contains a structural unit represented by General Formula (3),

[C2]

$$-[-(Y)_n- \quad -(Z)_m-]_b- \qquad (3)$$

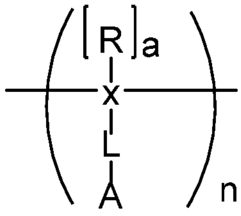

(3n)

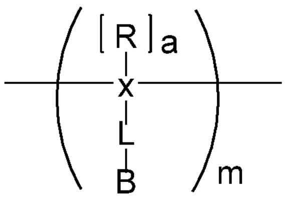

(3m)

where Y is a structural unit represented by Formula (3n), Z is a structural unit represented by Formula (3m), and these may be the same as or different from each other for each repeating unit,

n and m represent a molar ratio abundance, which is in a range of $0.01 \leq n \leq 1$ and $0 \leq m < 0.99$, and b represents an average number of repeating units and indicates a number of 2 to 1000,

x, A, L, R, and a are synonymous with those in General Formula (1), and

B's each independently indicate a hydrogen atom, a substituted or unsubstituted aromatic hydrocarbon group having 6 to 24 carbon atoms, a substituted or unsubstituted aromatic heterocyclic group having 3 to 18 carbon atoms, or a linked aromatic group in which a plurality of these aromatic rings are linked, and satisfy Formula (4),

$$S1(B) - T1(B) > 0.50 \qquad (4)$$

S1(B): lowest excited singlet energy of partial structure B

T1(B): lowest excited triplet energy of partial structure B

where the partial structure B represents B-L-Ph in which x to which B-L- is bonded is substituted with a phenyl group.

3. The polymer for organic electroluminescent devices according to claim 1, wherein the polymer for organic electroluminescent devices shows thermally activated delayed fluorescence characteristics.

4. The polymer for organic electroluminescent devices according to claim 1, wherein

in General Formula (1) or (3), A is a group generated from a structure represented by any of Formulas (5) to (9),

[C3]

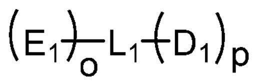

(5)

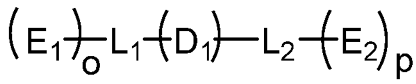

(6)

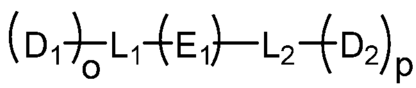

(7)

in Formulas (5), (6), and (7),

$E_1$ and $E_2$ each independently represent a structure or a substituent having electron-withdrawing properties,

$D_1$ and $D_2$ each independently represent a structure or a substituent showing electron-donating properties, $L_1$ and $L_2$ each independently represent a single bond, a substituted or unsubstituted aromatic hydrocarbon group having 6 to 24 carbon atoms, a substituted or unsubstituted aromatic heterocyclic group having 3 to 17 carbon atoms, or a linked aromatic group in which these aromatic rings are linked, and o and p each independently represent the number of substitutions and indicate an integer of 1 to 3, and

[C4]

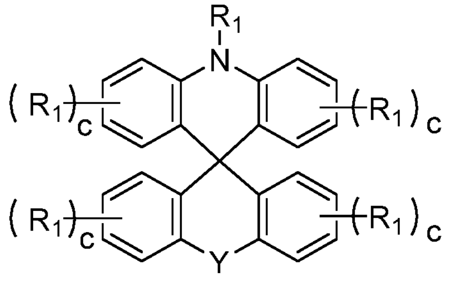

(8)

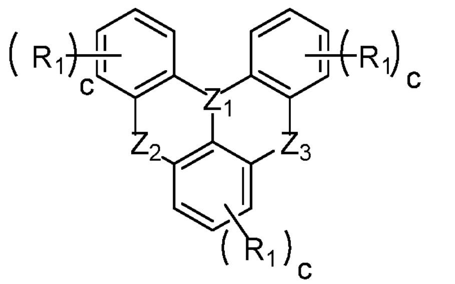

(9)

in Formulas (8) and (9), Y represents any of a single bond, S, $SO_2$, O, N-$R_1$, or C=O, $Z_1$ represents any of B, P=O, or P=S, and $Z_2$ and $Z_3$ each independently represent any of S, O, N-$R_1$, or C=O, $R_1$'s each independently represent deuterium, a halogen, a cyano group, a nitro group, an alkyl group having 1 to 20 carbon atoms, an aralkyl group having 7 to 38 carbon atoms, an alkenyl group having 2 to 20 carbon atoms, an alkynyl group having 2 to 20 carbon atoms, a dialkylamino group having 2 to 40 carbon atoms, a diarylamino group having 12 to 44 carbon atoms, a diaralkylamino group having 14 to 76 carbon atoms, an acyl group having 2 to 20 carbon atoms, an acyloxy group having 2 to 20 carbon atoms, an alkoxy group having 1 to 20 carbon atoms, an alkoxycarbonyl group having 2 to 20 carbon atoms, an alkoxycarbonyloxy group having 2 to 20 carbon atoms, an alkylsulfonyl group having 1 to 20 carbon atoms, an aromatic hydrocarbon group having 6 to 18 carbon atoms, an aromatic heterocyclic group having 3 to 18 carbon atoms, or a linked aromatic group in which a plurality of these aromatic rings are linked, and when these groups have a hydrogen atom, the hydrogen atom may be substituted with deuterium or a halogen, and c's each independently indicate an integer of 0 to 4, and when c is 2 or more, $R_1$'s may be bonded to each other to form a ring.

**5.** The polymer for organic electroluminescent devices according to claim 2, wherein Formula (3) is satisfied in General Formula (10),

$$S1(P3) - T1(P3) \leq 0.50 \qquad (10)$$

S1(P3): excited singlet energy of the polymer when b = 3
T1(P3): excited triplet energy of the polymer when b = 3.

**6.** The polymer for organic electroluminescent devices according to claim 1, wherein the polyphenylene structure of the main chain is linked at a meta position or an ortho position.

**7.** The polymer for organic electroluminescent devices according to claim 1, wherein the polymer is soluble polymer and a solubility in toluene at 40°C is 0.1 wt% or more.

**8.** The polymer for organic electroluminescent devices according to claim 1, wherein the polymer for organic electroluminescent devices is obtained by crosslinking and insolubilizing a polymer, which is soluble and has a reactive group at an end or a side chain of a polyphenylene structure, by heat or energy rays.

**9.** A composition for organic electroluminescent devices, wherein the composition for organic electroluminescent devices is formed by dissolving or dispersing, in a solvent, the polymer for organic electroluminescent devices according to any one of claims 1 to 8 alone or by mixing the polymer with another material.

**10.** A method for manufacturing an organic electroluminescent device, the method comprising applying the composition for organic electroluminescent devices according to claim 9 to form a film to obtain an organic layer.

**11.** An organic electroluminescent device comprising an organic layer containing the polymer for organic electroluminescent devices according to any one of claims 1 to 8.

[Fig. 1]

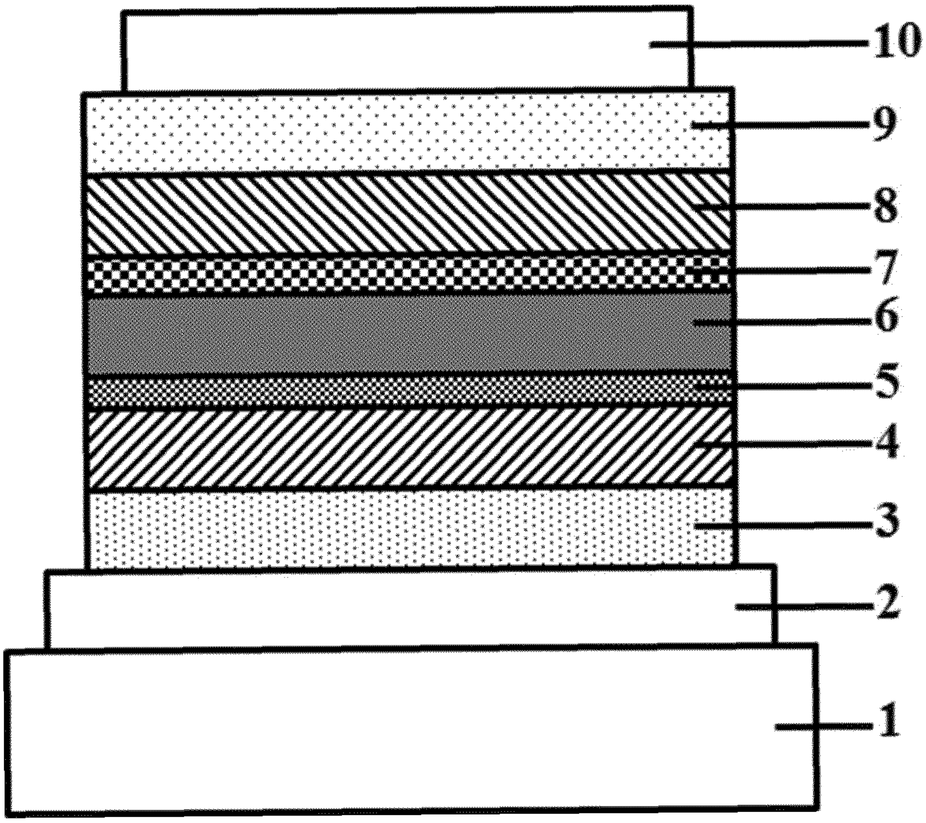
10
9
8
7
6
5
4
3
2
1

[Fig. 2]

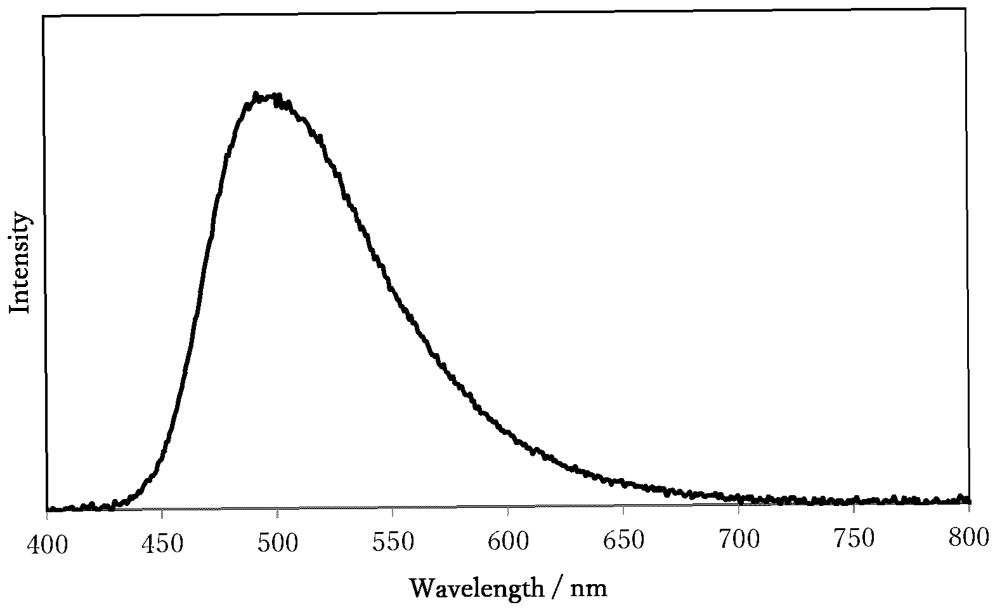
Intensity
400
450
500
550
600
650
700
750
800
Wavelength / nm

## INTERNATIONAL SEARCH REPORT

International application No. PCT/JP2020/011319

A. CLASSIFICATION OF SUBJECT MATTER
Int. Cl. C08G61/10(2006.01)i, C09K11/06(2006.01)i, H05B33/10(2006.01)i, H01L51/50(2006.01)i
FI: H05B33/14 B, H05B33/10, C08G61/10, C09K11/06 690, C09K11/06 680
According to International Patent Classification (IPC) or to both national classification and IPC

B. FIELDS SEARCHED
Minimum documentation searched (classification system followed by classification symbols)
Int. Cl. C08G61/10, C09K11/06, H05B33/10, H01L51/50

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)
CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| Y | WO 2019/004248 A1 (SUMITOMO CHEMICAL CO., LTD.) 03 January 2019, paragraphs [0007], [0008], [0355], [0384], [0404], [0405], [0409] | 1-11 |
| Y | WO 2019/004247 A1 (SUMITOMO CHEMICAL CO., LTD.) 03 January 2019, paragraphs [0007], [0047], [0157], [0160], [0165], [0166], [0194], [0196], [0197] | 1-11 |

☐ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 01.06.2020 | 09.06.2020 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2020/011319

| Patent Documents referred to in the Report | Publication Date | Patent Family | Publication Date |
|---|---|---|---|
| WO 2019/004248 A1 | 03.01.2019 | EP 3647338 A1<br>paragraphs [0006], [0007], [0267], [0295], [0309], [0310], [0314]-[0318]<br>CN 110799571 A<br>KR 10-2020-0023397 A | |
| WO 2019/004247 A1 | 03.01.2019 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2013057908 A
- JP 2004018787 A
- WO 2010134350 A
- WO 2011070963 A
- JP 2013053051 W
- WO 2012150712 A
- WO 2015002295 A


### Non-patent literature cited in the description


- *Appl. Phys. Lett.,* 1991, vol. 59, 2760
- *J. Am. Chem. Soc.,* 2001, vol. 123, 4304
- *Nature,* 2012, vol. 492, 234
- *Nature Photonics,* 2014, vol. 8, 326